# EUROPEAN PATENT APPLICATION

(11) **EP 4 793 787 A1**
(43) Date of publication of application: **19.08.2026**
(21) Application number: 26157481.8
(22) Date of filing: 10.02.2026
(51) Int. Cl.: G06F 15/78

(54) **DEVICE, SYSTEM, AND METHOD FOR PROCESSING IN MEMORY**

(30) Priority: 14.02.2025 US 202563759021 P; 08.10.2025 US 202519353594
(71) Applicant: Samsung Electronics Co., Ltd., Suwon-si, Gyeonggi-do 16677 (KR)
(72) Inventor: MARTINEAU, Jason, San Jose, CA, 95134 (US); LEE, Jeonil, 16677 Suwon-si, Gyeonggi-do (KR)
(74) Representative: Kuhnen & Wacker Patent- und Rechtsanwaltsbüro PartG mbB

(57) **Abstract**

A processing element (510) is disclosed. The processing element (510) may include a memory array (305) to store at least a first value and a second value. The processing element (510) may also include a first circuit (310, 320) to access the first value and the second value from the memory array (305). The processing element (510) may also include a multiply and accumulate, MAC, circuit (605) to process the first value and the second value to produce a third value. The processing element (510) may be part of a memory.

## Description

### FIELD

The disclosure relates generally to processing, and more particularly to processing instructions in memory.

### BACKGROUND

As the size of models used in Artificial Intelligence and other applications increases, the efficient processing of data becomes a greater concern. For example, Artificial Intelligence and large models may involve matrix multiplication: as the size of the matrices increases, the number of computations required to perform matrix multiplication may increase as the cube of the dimensions of the matrices. Moving such amounts of data between memory and processor to perform such multiplications is a potential bottleneck for efficiency, delaying other processing that may depend on the matrix multiplication.

Any specifics described above, such as specific implementations or values, are for example only, and should not be considered to be limiting or even admitted prior art.

A need remains to improve the efficiency of executing instructions on large data.

### BRIEF DESCRIPTION OF THE DRAWINGS

The drawings described below are examples of how embodiments of the disclosure may be implemented, and are not intended to limit embodiments of the disclosure. Individual embodiments of the disclosure may include elements not shown in particular figures and/or may omit elements shown in particular figures. The drawings are intended to provide illustration and may not be to scale.
FIG. 1 shows a machine including an acceleration device, according to embodiments of the disclosure.
FIG. 2 shows details of the machine of FIG. 1, according to embodiments of the disclosure.
FIG. 3 shows an example of a prior art memory architecture.
FIG. 4 shows dies, including a designated memory die, processor-in-memory dies, and a logic die, in the acceleration device of FIG. 1, according to embodiments of the disclosure.
FIG. 5 shows details of the processor-in-memory die, including processing elements, of FIG. 4, according to embodiments of the disclosure.
FIG. 6 shows details of the processing elements of FIG. 5, according to embodiments of the disclosure.
FIG. 7 shows how the processing elements of FIG. 5 may perform matrix multiplication, according to embodiments of the disclosure.
FIG. 8 shows how the processing elements of FIG. 5 may perform partial matrix multiplication, according to embodiments of the disclosure.
FIG. 9A shows a data flow diagram for the processing elements of FIG. 5 to perform a matrix multiplication, according to embodiments of the disclosure.
FIG. 9B continues the data flow diagram of FIG. 9A showing a data flow diagram for the processing elements of FIG. 5 to perform a matrix multiplication, according to embodiments of the disclosure.
FIG. 9C continues the data flow diagram of FIGs. 9A-9B showing a data flow diagram for the processing elements of FIG. 5 to perform a matrix multiplication, according to embodiments of the disclosure.
FIG. 9D continues the data flow diagram of FIGs. 9A-9C showing a data flow diagram for the processing elements of FIG. 5 to perform a matrix multiplication, according to embodiments of the disclosure.
FIG. 10 shows a flowchart of an example procedure for using the acceleration device of FIG. 1, according to embodiments of the disclosure.
FIG. 11 shows a flowchart of an example procedure for the processing elements of FIG. 5 to perform matrix multiplication, according to embodiments of the disclosure.
FIG. 12 shows a flowchart of an example procedure for values to be copied into the mat of FIG. 6, according to embodiments of the disclosure.
FIG. 13 shows a flowchart of an example procedure for the multiply and accumulate circuit (MAC) of FIG. 6 to copy values into the buffer of FIG. 6, according to embodiments of the disclosure.
FIG. 14 shows a flowchart of an example procedure for the MAC of FIG. 6 to determine the precision to use with the values in the mat of FIG. 6, according to embodiments of the disclosure.
FIG. 15 shows a flowchart of an example procedure for the MAC of FIG. 6 to access the values, according to embodiments of the disclosure.
FIG. 16 shows a flowchart of an example procedure for the processing elements of FIG. 5 to return output values, according to embodiments of the disclosure.
FIG. 17A shows a flowchart of an example procedure for the logic die of FIG. 4 to instruct the processing elements of FIG. 5 to perform matrix multiplication, according to embodiments of the disclosure.
FIG. 17B continues the flowchart of FIG. 17A of the example procedure for the logic die of FIG. 4 to instruct the processing elements of FIG. 5 to perform matrix multiplication, according to embodiments of the disclosure.
FIG. 18 shows a flowchart of an example procedure for the logic die of FIG. 4 to load values into the mat of FIG. 6 for the processing elements of FIG. 5 to perform matrix multiplication, according to embodiments of the disclosure.
FIG. 19 shows a flowchart of an example procedure for the logic die of FIG. 4 to provide the processing elements of FIG. 5 with the precision to use with the values in the mat of FIG. 6 and the number of elements in the rows/columns of the input matrices, according to embodiments of the disclosure.
FIG. 20 shows a flowchart of an example procedure for the logic die of FIG. 4 to specify the address where the processing elements of FIG. 5 may store the output values, according to embodiments of the disclosure.
FIG. 21 shows a flowchart of an example procedure for the logic die of FIG. 4 to store the output values produced by the processing elements of FIG. 5, according to embodiments of the disclosure.

### SUMMARY

A processing element that is part of a memory may include an array of memory cells (a mat) to store values used in executing instructions. A first circuit may access a first value and a second value from the mat. A second circuit may process the first value and the second value to produce a third value.

According to an embodiment, a processing element is provided. The processing element comprises: a memory array to store at least a first value and a second value; a first circuit to access the first value and the second value from the memory array; and a multiply and accumulate (MAC) circuit to process the first value and the second value to produce a third value, wherein the processing element is within a memory.

According to an embodiment, a processor-in-memory die is provided. The processor-in-memory die comprises: a first processing element including: a first memory array to store at least a first value and a second value; a first circuit to access the first value and the second value from the first memory array; and a first multiply and accumulate (MAC) circuit to process the first value and the second value to produce a third value; a second processing element including: a second memory array to store at least a fourth value and a fifth value; a second circuit to access the fourth value and the fifth value from the second memory array; and a second MAC circuit to process the fourth value and the fifth value to produce a sixth value; and a bank buffer where the first processing element may store the third value and the second processing element may store the sixth value.

According to an embodiment, a method is provided. The method comprises: receiving at a multiply and accumulate (MAC) circuit an instruction from a logic die to process a first value and a second value stored in a memory array associated with the MAC circuit, a first processing element including the memory array and the MAC circuit, a processor-in-memory die including the first processing element, a second processing element, and a bank buffer; accessing the first value and the second value from the memory array; processing the first value and the second value at the MAC circuit according to the instruction to produce a third value; and storing the third value by the MAC circuit.

### DETAILED DESCRIPTION

Reference will now be made in detail to embodiments of the disclosure, examples of which are illustrated in the accompanying drawings. In the following detailed description, numerous specific details are set forth to enable a thorough understanding of the disclosure. It should be understood, however, that persons having ordinary skill in the art may practice the disclosure without these specific details. In other instances, well-known methods, procedures, components, circuits, and networks have not been described in detail so as not to unnecessarily obscure aspects of the embodiments.

It will be understood that, although the terms first, second, etc. may be used herein to describe various elements, these elements should not be limited by these terms. These terms are only used to distinguish one element from another. For example, a first module could be termed a second module, and, similarly, a second module could be termed a first module, without departing from the scope of the disclosure.

The terminology used in the description of the disclosure herein is for the purpose of describing particular embodiments only and is not intended to be limiting of the disclosure. As used in the description of the disclosure and the appended claims, the singular forms "a", "an", and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The components and features of the drawings are not necessarily drawn to scale.

As computing moves farther into using Artificial Intelligence (AI), computing demands become greater. AI processing may involve executing many iterations of similar instructions, each of which may involve executing thousands, millions, billions, or more instructions. For example, AI processing often involves matrix multiplication: if the design for an AI model involves, for example, 94 levels of processing, each of which includes a matrix multiplication, then there are 94 matrix multiplications to be performed. Matrix multiplication is itself a multi-step process: to determine the value for one element in the output matrix involves multiplying corresponding elements in one row in the first input matrix and one column in the second input matrix, and summing the resulting products. Thus, for example, if the dimensions of the first input matrix are 100×50 and the dimensions of the second input matrix are 50×10, then there are 100 rows in the first input matrix, each including 50 elements, and 10 columns in the second input matrix, each also including 50 elements. Calculating a single element in the output matrix involves 50 multiplications, followed by a summing. Since the dimensions of the output matrix is 100×10, there are 1000 entries in the output matrix, meaning that this process is performed 1000 times. Thus, there are 50,000 multiplications performed just to perform this one matrix multiplication. And these input matrices are small: matrices used in AI large language models might be 50257×12288, and may become larger still. The numbers above are all exemplary: matrices may grow larger over time, making the problem of performing matrix multiplication more operation- and time-intensive. And while matrices used in AI models currently are two-dimension, the problem generalizes to matrices including more than two dimensions, further increasing the number of operations to perform matrix multiplication.

The amount of data involved in performing matrix multiplications, and especially for AI models, may be immense. Moving these large amounts of data between main memory and processor to perform such calculations may be a time-consuming process, increasing the latency of operations.

Embodiments of the disclosure address these concerns by performing the processing in memory, thereby enabling faster processing, such as matrix multiplication, by avoiding the need to move data from memory to the processor to execute instructions. The memory may actually be an accelerator or other processing device that leverages a memory design, such as high bandwidth memory. Each die may include multiple processing elements, each of which may process calculations to calculate individual values for the output matrix in a matrix multiplication. Each processing element may include its own mat to store data, circuitry to read the data from the mat, and circuitry to process the data and generate an output. This output may then be stored in a designated location. In an architecture such as a high bandwidth memory (HBM) architecture, this designated location may be in a bank buffer, which may also be used to store outputs from other processing elements within the same bank. A global controller may be responsible for loading data into the mats of each processing element and for transferring the output values to construct the output matrix.

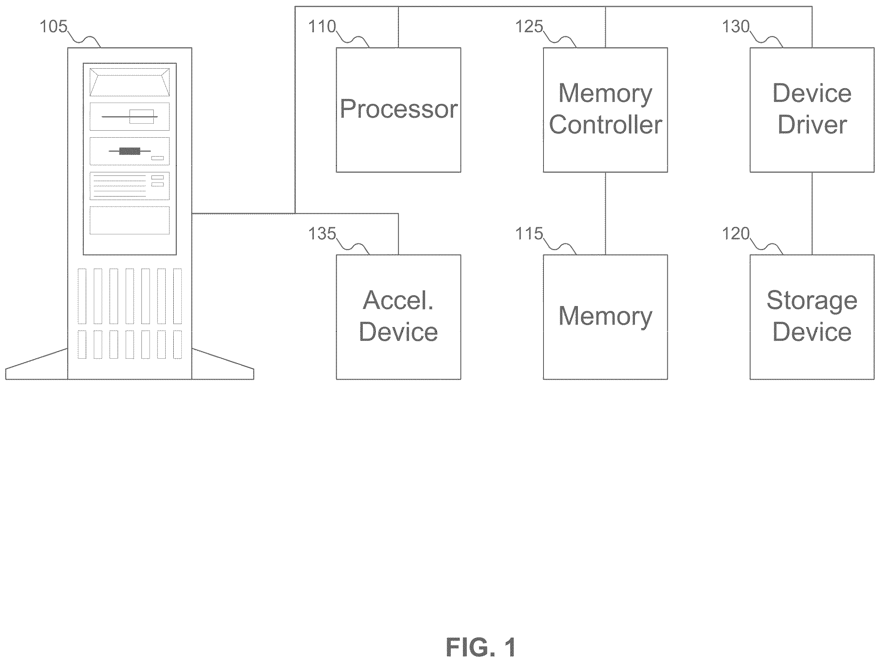

FIG. 1 shows a machine including an acceleration device, according to embodiments of the disclosure. The machine of FIG. 1 may enable execution of instructions in an accelerator that may leverage a memory architecture. In FIG. 1, machine 105, which may also be termed a host or a system, may include processor 110, memory 115, and storage device 120. While FIG. 1 shows one storage device 120, embodiments of the disclosure may include any number of storage devices 120.

Processor 110, which may also be referred to as a host processor, may be any variety of processor. Processor 110, along with the other components discussed below, are shown outside the machine for ease of illustration: embodiments of the disclosure may include these components within the machine. While FIG. 1 shows a single processor 110, machine 105 may include any number (one or more, without bound) of processors, each of which may be single core or multi-core processors, each of which may implement a Reduced Instruction Set Computer (RISC) architecture or a Complex Instruction Set Computer (CISC) architecture (among other possibilities), and may be mixed in any desired combination. Processor 110 may include registers (the collection of registers may be termed a register file).

Processor 110 may be coupled to memory 115. Memory 115, which may also be referred to as a main memory, may be any variety of memory, such as flash memory, Dynamic Random Access Memory (DRAM), Static Random Access Memory (SRAM), Persistent Random Access Memory, Ferroelectric Random Access Memory (FRAM), High Bandwidth Memory (HBM), or Non-Volatile Random Access Memory (NVRAM), such as Magnetoresistive Random Access Memory (MRAM) etc. Memory 115 may also be any desired combination of different memory types, and may be managed by memory controller 125. Memory 115 may be used to store data that may be termed "short-term": that is, data not expected to be stored for extended periods of time. Examples of short-term data may include temporary files, data being used locally by applications (which may have been copied from other storage locations), and the like.

Processor 110 and memory 115 may also support an operating system under which various applications may be running. These applications may issue requests (which may also be termed commands) to read data from or write data to either memory 115 or storage device 120. Whereas memory 115 may be used to store data that is considered "short-term", storage device 120 may be used to store data that is considered "long-term": that is, data that is expected to be retained for longer periods of time and that should be retained in a persistent manner, even if delivery of power to machine 105 should be interrupted. Storage device 120 may be accessed using device driver 130. While FIG. 1 shows one device driver 130 being used to manage access to storage device 120, embodiments of the disclosure may include more than one device driver 130, each used to manage access to different storage devices 120, or a single device driver 130 may be used to manage access to all storage devices 120.

Storage device 120 may be associated with an accelerator. In some embodiments of the disclosure, this accelerator may be acceleration device 135, which may also be referred to as an accelerator or a device; in other embodiments of the disclosure, the accelerator associated with storage device 120 may be separate from acceleration device 135. Such an accelerator may be used for, for example, near-data processing. That is, the accelerator may be used to process data closer to storage device 120, to reduce or eliminate transfer of data from storage device 120 into memory 115. The use of an accelerator for near-data processing may also offload processing from processor 110, as the accelerator may perform such processing instead of processor 110. Like processor 110, such an accelerator may implement a Reduced Instruction Set Computer (RISC) architecture or a Complex Instruction Set Computer (CISC) architecture (among other possibilities), and may be implemented, for example, using a Central Processing Unit (CPU), a Field Programmable Gate Array (FPGA), an Application-Specific Integrated Circuit (ASIC), a System-on-a-Chip (SoC), a Graphics Processing Unit (GPU), a General Purpose GPU (GPGPU), a Neural Processing Unit (NPU), or a Tensor Processing Unit (TPU).

The combination of storage device 120 and accelerator may also be referred to as a computational storage device, computational storage unit, computational storage device, or computational device. Storage device 120 and an accelerator may be designed and manufactured as a single integrated unit, or the accelerator may be separate from storage device 120. The phrase "associated with" is intended to cover both a single integrated unit including both a storage device and an accelerator and a storage device that is paired with an accelerator but that are not manufactured as a single integrated unit. In other words, a storage device and an accelerator may be said to be "paired" when they are physically separate devices but are connected in a manner that enables them to communicate with each other. Further, in the remainder of this document, any reference to storage device 120 may be understood to refer to both storage device 120 and the accelerator either as physically separate but paired (and therefore may include the other device) or to both devices integrated into a single component as a computational storage unit.

In addition, the connection between the storage device and the paired accelerator might enable the two devices to communicate, but might not enable one (or both) devices to work with a different partner: that is, the storage device might not be able to communicate with another accelerator, and/or the accelerator might not be able to communicate with another storage device. For example, the storage device and the paired accelerator might be connected serially (in either order) to the fabric, enabling the accelerator to access information from the storage device in a manner another accelerator might not be able to achieve.

While FIG. 1 uses the generic term "storage device", embodiments of the disclosure may include any storage device formats that may be associated with computational storage, examples of which may include hard disk drives, Solid State Drives (SSDs), flash arrays, and other types of non-volatile memory. In addition, in systems that include multiple storage devices 120, storage devices 120 may be of the same or different types. For example, one storage device 120 might be an SSD, whereas another storage device 120 might be a hard disk drive. Any reference to a specific type of storage device, such as an "SSD", below should be understood to include such other embodiments of the disclosure.

Processor 110 and storage device 120 may communicate across a fabric (not shown in FIG. 1). This fabric may be any fabric along which information may be passed. Such fabrics may include fabrics that may be internal to machine 105, and which may use interfaces such as Peripheral Component Interconnect Express (PCIe), Serial AT Attachment (SATA), or Small Computer Systems Interface (SCSI), among others. Such fabrics may also include fabrics that may be external to machine 105, and which may use interfaces such as Ethernet, Infiniband, or Fibre Channel, among others. In addition, such fabrics may support one or more protocols, such as Non-Volatile Memory Express (NVMe), NVMe over Fabrics (NVMe-oF), Simple Service Discovery Protocol (SSDP), or a cache-coherent interconnect protocol, such as the Compute Express Link ^{®} (CXL^{®}) protocol, among others. (Compute Express Link and CXL are registered trademarks of the Compute Express Link Consortium in the United States.) Thus, such fabrics may be thought of as encompassing both internal and external networking connections, over which commands may be sent, either directly or indirectly, to storage device 120. In embodiments of the disclosure where such fabrics support external networking connections, storage device 120 might be located external to machine 105, and storage device 120 might receive requests from a processor remote from machine 105.

In some embodiments of the disclosure, machine 105 may also include acceleration device 135. Acceleration device 135 may be a computational device that leverages the architecture of various types of memory, such as HBM. While the discussion below focuses on acceleration device 135 using an architecture like HBM, embodiments of the disclosure may also support other memory-like architectures.

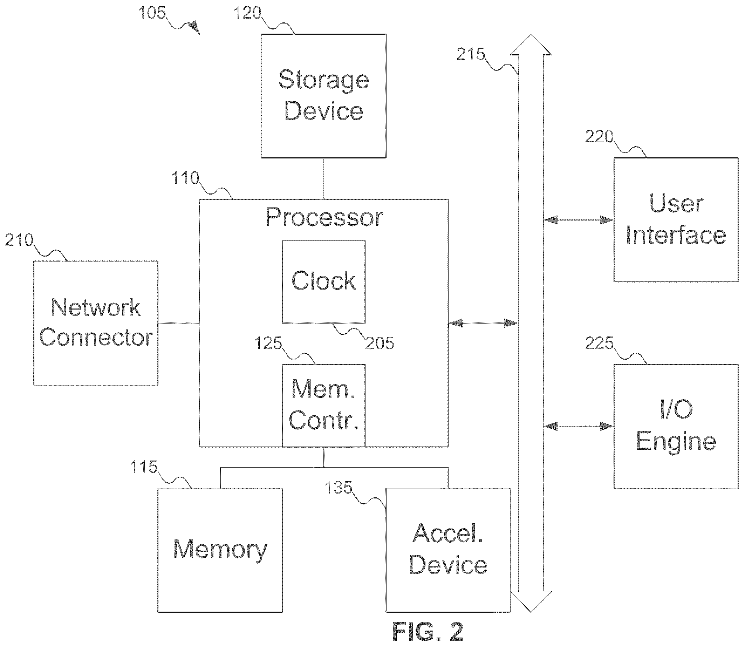

FIG. 2 shows details of the machine of FIG. 1, according to embodiments of the disclosure. In FIG. 2, typically, machine 105 includes one or more processors 110, which may include memory controllers 125 and clocks 205, which may be used to coordinate the operations of the components of the machine. Processors 110 may also be coupled to memories 115 and acceleration device 135, which may include random access memory (RAM), read-only memory (ROM), or other state preserving media, as examples. Processors 110 may also be coupled to storage device 120, and to network connector 210, which may be, for example, an Ethernet connector or a wireless connector. Processors 110 may also be connected to buses 215, to which may be attached user interfaces 220 and Input/Output (I/O) interface ports that may be managed using I/O engines 225, among other components.

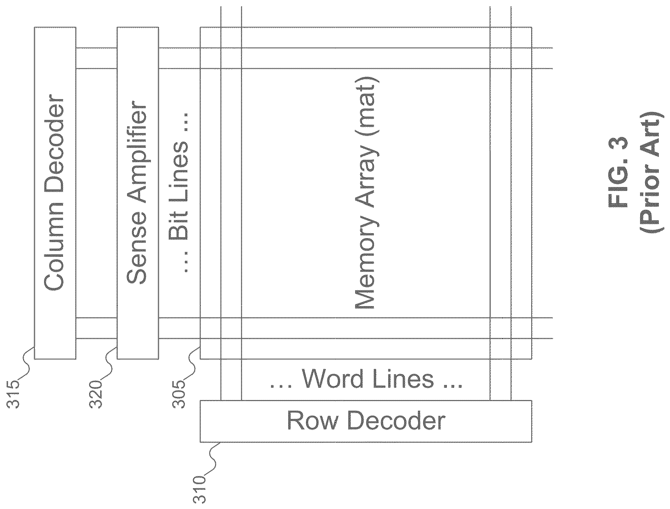

FIG. 3 shows an example of a prior art memory architecture. In FIG. 3, an example of a DRAM architecture is shown. The DRAM module may include memory array 305, which may be an array of memory cells and may also be referred to as a mat. The DRAM module may receive signals from a memory controller, such as memory controller 125 of FIG. 1, which may specify the address of the data being accessed. Row decoder 310 (which may also be referred to as row address related circuitry or a row circuit) may then activate the appropriate word lines, and column decoder 315 (which may also be referred to as column address related circuitry or a column circuit) may activate the appropriate bit lines, based on the address being accessed. At the intersection of the word lines and the bit lines may be a storage element that may store one or more bits of data. Sense amplifier 320 may then sense which lines are activated and may then return the appropriate bit value(s) back to memory controller 125 of FIG. 1 (and ultimately to, for example, processor 110 of FIG. 1).

In some embodiments, the DRAM module might include just one memory array. But with DRAM modules now storing many gigabytes of data, it is not unusual for a DRAM module to be divided into banks, and the banks subdivided into smaller arrays of memory cells. These smaller arrays of memory cells may be referred to as mats. Each mat may include, for example, 1024 rows and 1024 columns, or a total of 1,048,576 cells. Thus, for example, an 8 gigabyte (GB) DRAM module might include two banks, each including 4096 mats. Note that all of these numbers are merely exemplary, and DRAM modules may include other overall capacities, other numbers of banks, other mat sizes, and other numbers of mats.

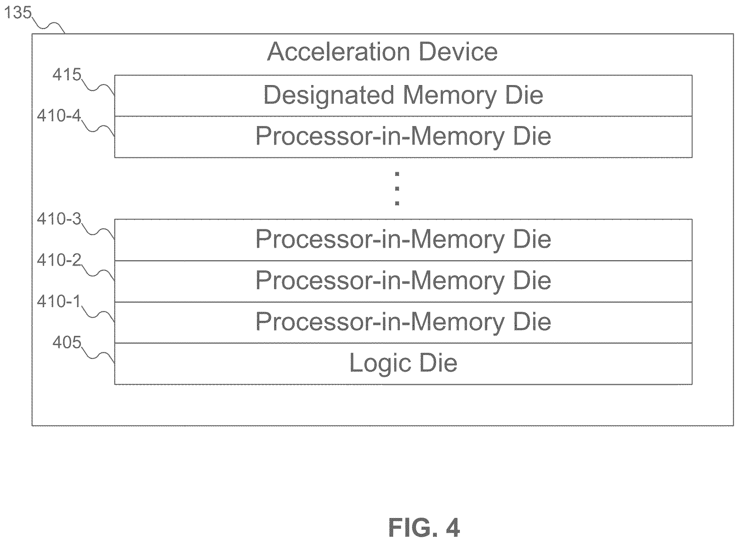

FIG. 4 shows dies in acceleration device 135 of FIG. 1, according to embodiments of the disclosure. As discussed with reference to FIG. 1 above, in FIG. 4 acceleration device 135 is described as leveraging an HBM memory architecture, but other embodiments of the disclosure may support other memory architectures with minor variations in implementation.

In FIG. 4, acceleration device 135 is shown as including logic die 405. Logic die 405 may also be referred to as a global controller. Logic die 405 may enable various functions. For example, logic die 405 may act as an interface for acceleration device 135, may control the operations of the memory cells in the other dies (such as reading, writing, or erasure of data), control the computations performed by the processor-in-memory dies (by assigning data to the various mats in the processor-in-memory dies and specifying where the outputs of any such calculations may be stored: for example, in the designated memory die). Logic die 405 may also be responsible for command management (such as queue management, command reordering, scheduling, and prioritization), data integrity and reliability (such as error correction and command parity), power management (such as changing power modes or refreshing of data stored memory), thermal control and management (such as managing temperature variations and throttling command execution in case dies overheat), memory security and protection, and read or write after write coherency, among other functions. In short, logic die 405 may function similarly to a global controller in DRAM or HBM, with the added capability of managing computation within the processor-in-memory dies. Logic die 405 may also include some computing capability itself (and therefore may also perform computations directly on data), but more generally is responsible for managing the data to be processed in acceleration device 135 coordinating the co-location of data with processing elements within acceleration device 135. To that end, logic die 405 may load data into the various other dies in acceleration device 135, instruct various dies in acceleration device 135 to perform processing, and handle the disposition of output values as processed by the various dies in acceleration device 135, as discussed below.

Acceleration device 135 may also include various processor-in-memory dies 410-1, 410-2, 410-3, and 410-4, which may be referred to collectively as processor-in-memory dies 410. While FIG. 4 shows acceleration device 135 as including four processor-in-memory dies 410, embodiments of the disclosure may include any number (one or more) of processor-in-memory dies 410. Processor-in-memory dies 410 may include storage for data along with the circuitry to process that data.

Finally, acceleration device 135 may include designated memory die 415. In contrast with processor-in-memory dies 410, designated memory die 415 may be a memory die that stores data to be used as input to and output from processor-in-memory dies 410. In this context, "designated" means that memory die 415 is "designated" to store data, rather than being a logic die or a processor-in-memory die. To that end, designated memory die 415 might not include any processing capability (although designated memory die 415 might also include processing capability, whether or not utilized). While FIG. 4 shows acceleration device 135 as including only one designated memory die 415, embodiments of the disclosure may include any number (one or more) of designated memory dies 415, depending on the amount of data to be stored therein.

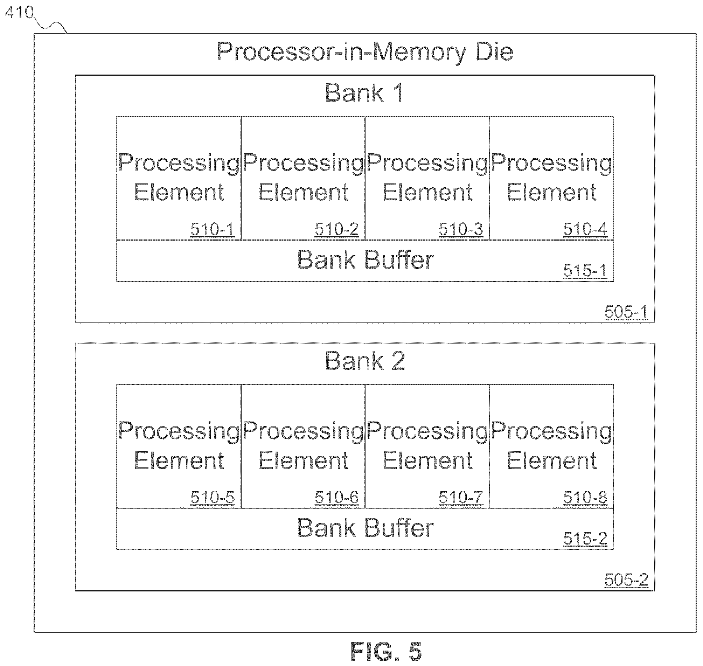

FIG. 5 shows details of processor-in-memory die 410 of FIG. 4, according to embodiments of the disclosure. In FIG. 5, processor-in-memory die 410 is shown as including two banks 505-1 and 505-2, which may be referred to collectively as banks 505. While FIG. 5 shows processor-in-memory die 410 as including two banks 505, embodiments of the disclosure may have processor-in-memory die 410 including any number (one or more) of banks 505, although some embodiments of the disclosure may include two or four banks 505.

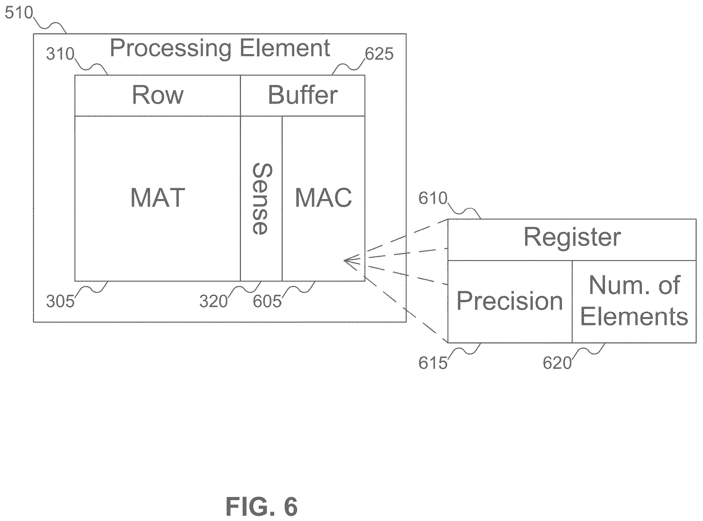

Each bank 505 may include various processing elements. For example, bank 505-1 is shown as including processing elements 510-1, 510-2, 510-3, and 510-4, and bank 505-2 is shown as including processing elements 510-5, 510-6, 510-7, and 510-8 (processing elements 510-1 through 510-8 may be referred to collectively as processing elements 510). Processing elements 510 may be where data is both stored and processed in processor-in-memory die 410. While FIG. 5 shows each bank 505 as including four processing elements 510, embodiments of the disclosure may include any number (one or more) of processing elements 510. For example, if each processor-in-memory die 410 is capable of storing 2 GB of data, and each processing element 510 is capable of storing 1,048,576 bits of data (as discussed with reference to FIG. 6 below), then there may be 16,384 processing elements per processor-in-memory die 410. If processor-in-memory die 410 includes two banks 505, then each bank 505 includes 8,192 processing elements 510. As may be understood from the discussion above and further below, the number of processing elements 510 on processor-in-memory die 410 may be related to the size of a mat within a bank, as well as the size of each bank, and the number of banks per die.

Each bank 505 may also include a bank buffer. For example, bank 505-1 is shown as including bank buffer 515-1, and bank 505-2 is shown as including bank buffer 515-2 (bank buffers 515-1 and 515-2 may be referred to collectively as bank buffers 515). Each bank buffer 515 may be accessible by all processing elements 510 in the corresponding bank 505. While FIG. 5 shows each bank 505 as including one bank buffer 515, embodiments of the disclosure may have each bank 505 include any number (one or more) of bank buffers 505. In addition, where a bank 505 includes more than one bank buffer 515, those bank buffers 515 may be shared among some or all of processing elements 510 in that bank 505, depending on the embodiment of the disclosure. While each bank 505 in processor-in-memory die 410 may be implemented identically, embodiments of the disclosure may also support different banks 505 being implemented differently: for example, by including different numbers of processing elements 510 and/or bank buffers 515. In addition, while each processor-in-memory die 410 may be implemented identically, embodiments of the disclosure may also support different processor-in-memory dies 410 being implemented differently: for example, by including different numbers of banks 505, processing elements 510, and/or bank buffers 515.

While FIG. 5 might suggest that processing elements 510 are arranged as a linear array with each bank 505, embodiments of the disclosure may support arranging processing elements 510 in any desired configuration. For example, processing elements 510 may be arranged in a square or grid configuration, while still offering each processing element 510 access to bank buffer 515.

FIG. 6 shows details of processing elements 510 of FIG. 5, according to embodiments of the disclosure. In FIG. 6, processing element 510 is shown. The processing element 510 of FIG. 6 which is included in the Processor-in-Memory Die of FIG. 5 is an example of a processing element within a memory. Processing element 510 may include memory array 305. Memory array 305 may be an array of memory (e.g., DRAM) cells, each of which may store one or more bits of data. Common implementations of memory array 305 may include arrays of 512×512 cells or 1024×1024 cells, but embodiments of the disclosure may support other sizes for memory array 305.

To access cells from memory array 305, row circuit 310 and sense amplifier 320 may be used. Row circuit 310 may activate a row in memory array 305, and sense amplifier 320 may amplify the signal from memory array 305 to a digital voltage level. Either individually or in combination, row circuit 310 and/or sense amplifier 320 may be considered a first circuit in processing element 510. Note that processing element 510 does not necessarily include column address related circuitry, such as column decoder 315 of FIG. 3. A column address related circuitry (which, as noted above, may also be referred to as a column circuit) might be used to activate a particular column in memory array 305, thereby isolating a particular cell in memory array 305. By not including a column circuit, the entire row from memory array 305 may be returned for processing. This distinguishes processing element 510 from a mat used in ordinary memory, which may isolate on a particular cell rather than a particular row in memory array 305. As such, acceleration device 135 of FIG. 1 may not be used in place of (or in addition to) memory 115 of FIG. 1 as an HBM: acceleration device 135 of FIG. 1 is an accelerator built on an HBM architecture, but is not an HBM itself. But some embodiments of the disclosure may include a column circuit as well, to support using acceleration device 135 in place or (or in addition to) memory 115 of FIG. 1.

As noted above, processing element 510 might omit a column circuit. In its place (or in addition to a column circuit), processing element 510 may include multiply and accumulate circuit (MAC) 605. Herein, MAC 605 may be referred to as MAC circuit 605. MAC 605 may be considered a second circuit in processing element 510. MAC 605 may perform multiply and accumulate operations on values stored in memory array 305. MAC 605 may be implemented as any desired circuit, including digital logic gates, an FPGA, an ASIC, an SoC, a GPU, a GPGPU, an NPU, or a TPU, among other possibilities. While FIG. 6 shows MAC 605 as performing a multiply and accumulate operation, MAC 605 may also be replaced with other circuits to perform other operations.

MAC 605 may also include register 610. Register 610 (which may take any desired form of storage, including non-volatile storage such as a flash memory, and may also be referred to as a storage) may be used to store information relevant to the operations of MAC 605. For example, precision 615, or the number of bits, used by each value stored in memory array 305 may be relevant, so that MAC 605 knows where one value ends in memory array 305 and another value begins. Thus, if all values stored in memory array 305 are no larger than 15, then precision 615 may be stored as four, to indicate that no value uses more than four bits (2⁴ = 16). Or number of elements 620, which may specify how many values there are in a given row or column of the input matrices, may be relevant, so that MAC 605 knows where one row or column ends in memory array 305 and another row or column in the matrix begins. Thus, if number of elements 620 is set to, say, 20, then MAC 605 knows that there are only 20 elements in each row or column of the input matrices, and any subsequent data may belong to another row or column of the input matrices. Other information necessary to program or control processing element 510 may also be stored in register 610.

Finally, processing element 510 may include buffer 625. Buffer 625 may be locally available memory for use by MAC 605. Values may be copied from memory array 305 into buffer 625 for processing by MAC 605. Buffer 625 may store enough values to perform at least one iteration of calculations by MAC 605: for example, one row/column (or portion thereof) from the input matrices. Buffer 625 may be relatively larger than might be present in a mat of a memory module that does not support processing: for example, buffer 625 might be 2 kilobytes (KB) or 4 KB in size: large enough to store at least one row/column from most expected input matrices to perform matrix multiplication, and ideally large enough to store one row from one input matrix involved in the matrix multiplication and one column from the other input matrix involved in the matrix multiplication.

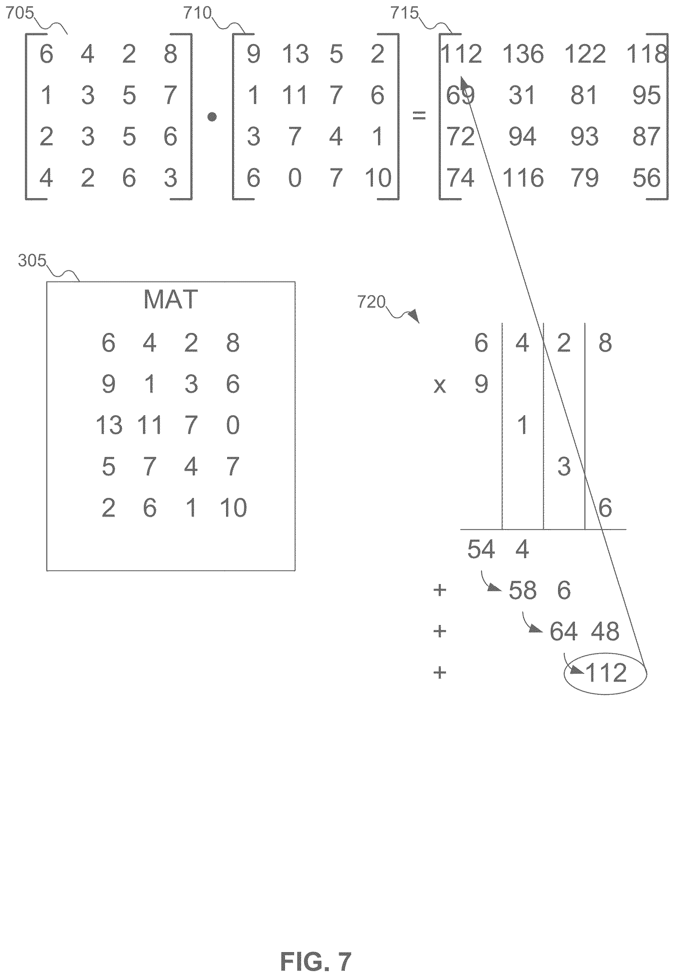

FIG. 7 shows how processing elements 510 of FIG. 5 may perform matrix multiplication, according to embodiments of the disclosure. FIG. 7 represents values using base 10 rather than binary, to simplify understanding: it should be understood that processing elements 510 may operate on binary data rather than decimal data. In FIG. 7, input matrices 705 and 710 are shown. While FIG. 7 shows input matrices 705 and 710 as both being 4×4 matrices, embodiments of the disclosure may include matrices of any sizes: the only limiting criteria is that the number of columns in input matrix 705 is equal to the number of rows in input matrix 710.

It is helpful to first understand how matrix multiplication operations work. Assume that matrix *A* has dimensions *i*×*j*: that is, matrix *A* has *i* rows and *j* columns, with the value in the *j*^{th} column of the *i*^{th} row designated as *a_{i,j}*. Similarly, matrix *B* has *j* rows and k columns, with the value in the *k*^{th} column of the *j*^{th} row designated as *b_{j,k}*. Then, the value of the *k*^{th} column in the *i*^{th} row of the output matrix may be represented as ${c}_{i , k} = {\sum }_{n = 1}^{j} {a}_{i , n} \times {b}_{n , k}$. Performing this calculation for each value of *i* and *k,* the output matrix *C* may be determined. Thus, for example, the first row of input matrix 705 includes the values [6, 4, 2, 8], and the first column of input matrix 710 includes the values [9, 1, 3, 6]. Thus, the value in the first row, first column of output matrix 715 may be calculated as (6×9) + (4×1) + (2×3) × (8×6), or 54 + 4 + 6 + 48, which is 112, as shown in the top left entry in output matrix 715. The other values in output matrix 715 may be computed in a similar fashion.

As may be seen by this description, matrix multiplication is not a complicated process, but it involves numerous arithmetic calculations. As calculating one element in output matrix 715 involves four multiplication operations and three addition operations, to calculate the entire output matrix 715 may involve 64 multiplication operations and 48 addition operations. (This calculation of 64 multiplication operations and 48 addition operations is based on decimal arithmetic: using binary arithmetic as may be expected using processing elements 510 of FIG. 5, the number of multiplication and addition operations may differ.) And input matrices 705 and 710 are relatively small: matrices in Artificial Intelligence (AI) may easily include hundreds of thousands, or millions, of entries. Thus, the total operations needed to perform a single matrix multiplication in AI may number in the billions. Hence, the value of using processing elements to perform such calculations, rather than moving huge amounts of data into main memory 115 of FIG. 1 to permit processor 110 of FIG. 1 to perform such processing.

To populate memory array 305, processor 110 of FIG. 1 may send a request to acceleration device 135 of FIG. 1. This request may be received at logic die 405 of FIG. 4. Logic die 405 of FIG. 4 may then load the data to be processed-for example, from memory 115 of FIG. 1-into designated memory die 415 of FIG. 4. The data to be processed in a particular memory array 305 may then be loaded from designated memory die 415 into that memory array 305: either by logic die 405 of FIG. 4 or by instructing memory array 305 where to access the data it is to process. Logic die 405 of FIG. 4 may also specify where the output of the processing of the data in memory array 305 is to be stored (which may be transferred into that location by memory array 305 or by MAC 605 of FIG. 6). When all mats 305 have finished their respective processing, then logic die 405 of FIG. 4 may return the output data to processor 110 of FIG. 1-for example, by copying the output data into memory 115 of FIG. 1.

Advantages of embodiments of the disclosure include that off-device data movement is reduced: with all computations being performed within the device, there is less need to move data in and out of acceleration device 135 to complete processing. Further, by pushing computation down to the mat level, there is a reduced need for local and global input/output operations: all the data that is to be processed in a particular memory array 305 is stored in that memory array 305.

FIG. 7 also shows how memory array 305 may be used to store information from input matrices 705 and 710 to enable MAC 605 of FIG. 6 to perform such computations. First, note that memory array 305 stores one row (or a portion of one row) from input matrix 705 (in the top row of memory array 305). In some embodiments of the disclosure, memory array 305 may store more than one row from input matrix 705: for ease of understanding, FIG. 7 shows memory array 305 as storing only one row from input matrix 705. Second, note that memory array 305 stores four columns from input matrix 710: but these columns have been transposed into rows in memory array 305 (the bottom four rows of memory array 305). This transposition of columns to rows may be performed by logic die 405 of FIG. 4 when data is loaded into memory array 305 from designated memory die 415 of FIG. 4. Thus, for example, the second row in memory array 305 has the values from the first column of input matrix 710, the third row in memory array 305 has the values from the second column in input matrix 710, and so on. This transposition may benefit the calculation of elements in output matrix 715 by MAC 605 of FIG. 6, since corresponding values in different rows may be loaded via a row-read operation, multiplied, and the products summed (as discussed below). Thus, because memory array 305 stores one row from input matrix 705 and four columns from input matrix 710, MAC 605 of FIG. 6 may calculate four values in output matrix 715 (corresponding to the first row of output matrix 715).

To calculate the value of an element in output matrix 715, the row from input matrix 705 and one column from input matrix 710 (shown as a row in memory array 305, due to the transposition of the vectors from columns to rows) may be processed. These rows might be loaded, for example, into buffer 625 of FIG. 6, or might be processed directly from memory array 305. Corresponding entries from the rows in memory array 305 may then be multiplied, and their respective products calculated. Thus, as shown in operation 720, the values 6 and 9 may be multiplied, the values of 4 and 1 may be multiplied, the values of 2 and 3 may be multiplied, and the values of 8 and 6 may be multiplied, producing the products 54, 4, 6, and 48. These products may then be summed, producing the final value 112, which then represents the value of a particular element in output matrix 715. If there are other rows in memory array 305 representing other columns from input matrix 710, these operations may be repeated to calculate values for other elements in output matrix 715.

Note that the above description explains how some of the elements in output matrix 715 may be calculated. But there are other elements that remain to be calculated: for example, the elements in rows two, three, and four of output matrix 715. In some embodiments of the disclosure, these elements may be calculated by other processing elements 510 of FIG. 5, which may operate in parallel with the operations shown described in FIG. 7. In other words, logic die 405 of FIG. 4 may distribute elements from input matrices 705 and 710 appropriately to multiple processing elements 510 of FIG. 5 to complete the calculations needed to determine output matrix 715. Note that this distribution of values might involve copying the same values into multiple mats 305: for example, if each processing element 510 of FIG. 5 is responsible for calculating one row in output matrix 715, each processing element 510 of FIG. 5 may need a copy of the entire input matrix 710 (although with copies of differing respective rows of input matrix 705).

While the above discussion focuses on how to multiply two matrices, processing elements 510 of FIG. 5 may also be used for other purposes. Generalizing from matrix multiplication, processing elements 510 of FIG. 5 may also be used for vector-matrix multiplication. A vector may be thought of as a matrix where one of the dimensions is 1: that is, a vector may be thought of as a matrix with only one row or only one column. As such, multiplying a vector and a matrix is a form of a degenerate case of matrix multiplication, and may be performed using the same techniques. Of course, processing elements 510 of FIG. 5 may be also be used for scalar matrix multiplication. A scalar is a constant value, rather than a matrix. Scalar matrix multiplication, therefore, is where each value in the matrix is multiplied by that constant. Scalar matrix multiplication involves fewer operations than matrix multiplication, but when performed on matrices involving potentially millions of elements, the number of operations to perform is still significant. Thus, using processing elements 510 of FIG. 5 to perform scalar matrix multiplication may still be of benefit.

Regardless of the operation being performed, processing element 510 of FIG. 5 may return the output value (or values, depending on how many calculations processing element 510 of FIG. 5 is capable of performing). These values may be stored in, for example, bank buffer 515 of FIG. 5 or designated memory die 415 of FIG. 4, at addresses specified by logic die 405 (and provided to processing element 510 of FIG. 5). Or, processing element 510 of FIG. 5 may return the values to logic die 405 of FIG. 4, leaving it to logic die 405 of FIG. 4 to decide where to store the data.

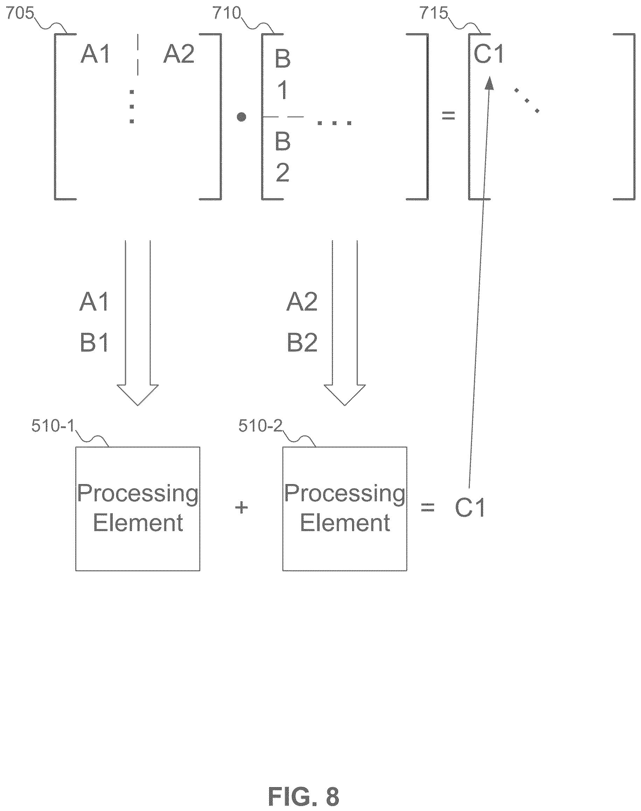

As noted above, the example matrix multiplication shown in FIG. 7 is a simplification for purposes of understanding. In some situations, storing a single row/column from input matrices 705 and 710 in memory array 305 may require many (*e.g*., 32) rows in memory array 305: potentially, as matrices become larger, even more rows might be required to store a single row/column from input matrices 705 and 710 in memory array 305. Thus, it might not be possible for MAC 605 of FIG. 6 to calculate the entire row/column product of the individual elements from input matrices 705 and 710 at one time. Instead, portions of each row/column may be processed as described above. In that case, MAC 605 of FIG. 6 might need to include storage or registers, such as a portion of register 610 of FIG. 6, for a carry over, to track the sums across multiple rows of data from memory array 305. If buffer 625 of FIG. 6 is used to store information for MAC 605 of FIG. 6 to process, and if memory array 305 stores 1024×1024 cells, and if buffer 625 of FIG. 6 is 4 KB in size, then buffer 625 of FIG. 6 ought to be large enough to store 32 rows from memory array 305 (32 × 1024 = 32,768 bits, or 4,096 bytes). But even this size for buffer 625 of FIG. 6 might be insufficient if the sizes of input matrices 705 and 710 increase further, in which case MAC 605 of FIG. 6 might utilize a larger buffer, or need to carry over information from one iteration to the next. This situation is discussed further with reference to FIG. 8.

Aside from the simplified example (which, again, is presented in base 10), processing element 510 of FIG. 5 might need to know the precision of the elements it is adding (and of its output), as this may impact how many bits are "sampled" for each element in the operations. For example, in FIG. 7 the element values all range from 0-15; thus each value may be represented with four bits. Accordingly, for the example processing element 510 of FIG. 5 may be programmed with an input precision of 4, and would sample 4 bits per operand. Likewise, the output elements are presented as (at most) a 16 bit number. But in other contexts, such as in machine learning contexts, this output may be re-normalized to a different precision (such as the same precision as the inputs). Processing element 510 of FIG. 5 may thus be programmed to perform this re-normalization (*e.g*., by rounding/dropping the least significant bits). As mentioned above, the precisions of the input and output may be specified in register 610 of FIG. 6, and may be provided to processing element 510 of FIG. 5 by logic die 405 of FIG. 4 in response to the overall request from processor 110 of FIG. 1 as a parameter of the operation to process the data in memory array 305.

While the above description focuses on how processing element 510 of FIG. 5 might calculate a single value in output matrix 715, it is worth noting that memory array 305 is shown as being large enough to contain the entirety of input matrix 710 (as well as one row from input matrix 705). Thus, processing element 510 of FIG. 5 containing memory array 305 might be able to calculate multiple values in output matrix 715: specifically, the values in the second, third, and fourth columns of the first row of output matrix 715. The operations performed by processing element 510 of FIG. 5 to calculate these additional values in output matrix 715 are the same as those described to calculate the value in the first column of the first row of output matrix 715: the only difference is that the multiply and accumulate operations are performed using other rows in memory array 305. For example, to calculate the value in the second column in the first row of output matrix 715, the first and third rows of memory array 305 may be used, to calculate the value in the third column in the first row of output matrix 715, the first and fourth rows of memory array 305 may be used, and to calculate the value in the fourth column in the first row of output matrix 715, the first and fifth rows of memory array 305 may be used.

It is also possible for memory array 305 to store more than one row from input matrix 705. In that case, additional rows in memory array 305 may be used to store additional rows from input matrix 705. For example, the first two rows of memory array 305 might store the first two rows of input matrix 705, and any columns from input matrix 710 may be transposed and stored in other rows in memory array 305.

In either of these variations, processing element 510 of FIG. 5 may be notified by logic die 405 of FIG. 4 regarding how much data is stored in memory array 305. Thus, if memory array 305 is large enough to store more than one row and/or one column from input matrices 705 and/or 710, logic die 405 of FIG. 4 may so notify processing element 510 of FIG. 5, so that processing element 510 of FIG. 5 knows how many output values it is to produce.

It is worth noting that while memory array 305 may be a grid storing values (although typically storing bits rather than decimal values in each cell), while the above description references "rows" in memory array 305, this description may be a simplification. For example, memory array 305 might simply store values in sequential order, without breaking data up along "rows" and "columns" like are shown in input matrices 705 and 710. Thus, for example, if memory array 305 includes 1024 rows and 1024 columns, each row in memory array 305 is large enough to store 128 8-bit values. But as input matrices 705 and 710 each only have 16 values (each of which only requiring four bits to store), technically the entirety of both of input matrices 705 and 710 may fit into a single row of memory array 305. Thus, using precision 615 of FIG. 6 and number of elements 620 of FIG. 6, processing element 510 of FIG. 5 may determine where one row/column of input matrices 705 and 710 ends and another row/column of input matrices 705 and 710 begins, even if not necessarily aligned with "rows" of memory array 305.

In situations where memory array 305 is large enough to store more than one row and/or column from input matrices 705 and/or 710, processing element 510 of FIG. 5 (more specifically, MAC 605 of FIG. 6) may effectively implement a "for loop" to process data for each potential output value it is to produce, using an FPGA, an ASIC, digital logic gates, or any other desired implementation.

FIG. 8 shows how processing elements 510 of FIG. 5 may perform partial matrix multiplication, according to embodiments of the disclosure. In FIG. 8, it is assumed that there is insufficient space in memory array 305 of FIG. 3 in processing element 510 of FIG. 5 in a single processing element 510 to store the entirety of both one row from input matrix 705 and one column from input matrix 710. Since determining a single element in output matrix 715 depends on an entire row from input matrix 705 and an entire column from input matrix 710, the fact that input matrices 705 and 710 are so large that they both may not fit in memory array 305 of FIG. 3 in processing element 510 of FIG. 5 means that no single processing element 510 may be able to calculate a single element in output matrix 715.

But because the calculation of the element in output matrix 715 is the sum of the pairwise product of elements in the row of input matrix 705 and the column of input matrix 710, the work to calculate an element in output matrix 715 may be divided between two processing elements 510. Thus, for example, the row in input matrix 705 may be divided into two portions, labeled A1 and A2, and the column of input matrix 710 may be similarly divided into two portions, labeled B1 and B2. Then, processing element 510-1 may be assigned to calculate the sum of the pairwise products of portions A1 and B1, and processing element 510-2 may be assigned to calculate the sum of the pairwise products of portions A2 and B2. The values returned by processing elements 510-1 and 510-2 may then be summed (for example, by logic die 405 of FIG. 4 or by another processing element 510 of FIG. 5 in a further operation) to produce the value C1 that goes in output matrix 715.

While the above example describes splitting rows/columns from input matrices 705 and 710 into two portions, embodiments of the disclosure may subdivide rows/columns of input matrices 705 and 710 to however many portions are needed. With each memory array 305 of FIG. 3 in processing element 510 of FIG. 5 potentially storing 1024×1024 = 1,048,576 bits or 131,072 bytes, each memory array 305 of FIG. 3 in processing element 510 of FIG. 5 has room for 131,072 one-byte values, or 65,536 two-byte values, or 16,384 eight-byte values. Thus, even needing eight bytes, or 64 bits, for the precision of the values stored in memory array 305 of FIG. 3 in processing element 510 of FIG. 5, each memory array 305 may store up to 8192 values from input matrix 705 and 8192 values from input matrix 710 with which to perform matrix multiplication. Thus, for example, if input matrices 705 and 710 each have 65,536 rows and columns, calculating a single value in output matrix 715 might involve eight processing elements 510 working together (each calculating a partial sum of products, with the final value calculated as the sum of the individual partial sums of products).

Note that the likelihood of needing eight byte precision is relatively low: most AI matrices may only require up to two-byte precision. Thus, each memory array 305 of FIG. 3 in processing element 510 of FIG. 5 may theoretically store up to 32,768 values from each of input matrices 705 and 710. Thus, in practice for current AI models, each memory array 305 of FIG. 3 in processing element 510 of FIG. 5 is large enough to store 32 rows/columns of some attention head matrices, or 5 rows/columns of some external or embedding matrices. Thus, the need to divide the work of matrix multiplication across multiple processing elements 510 shows the extendibility of embodiments of the disclosure for future needs beyond current practice.

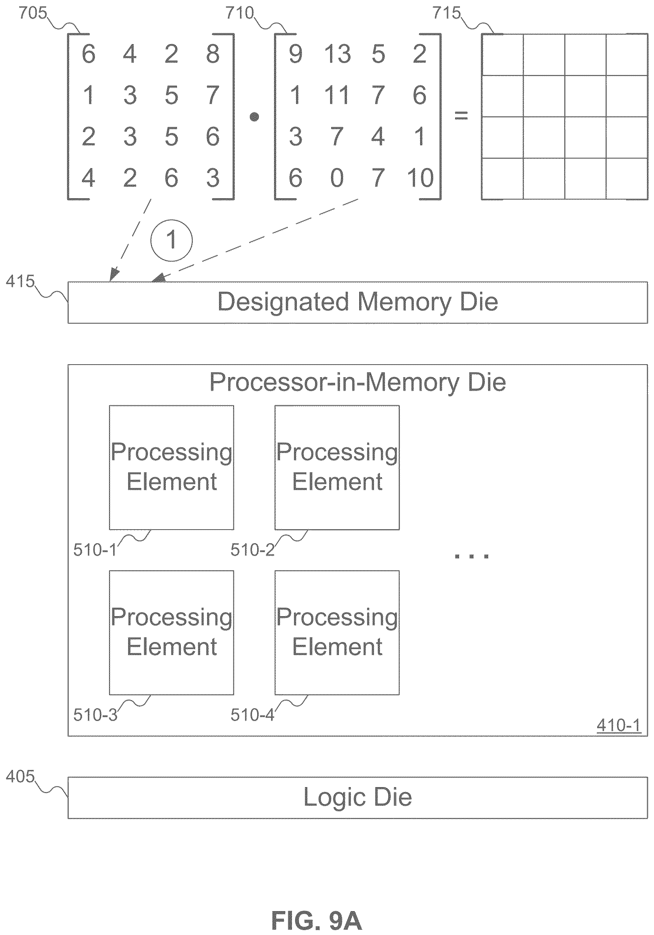

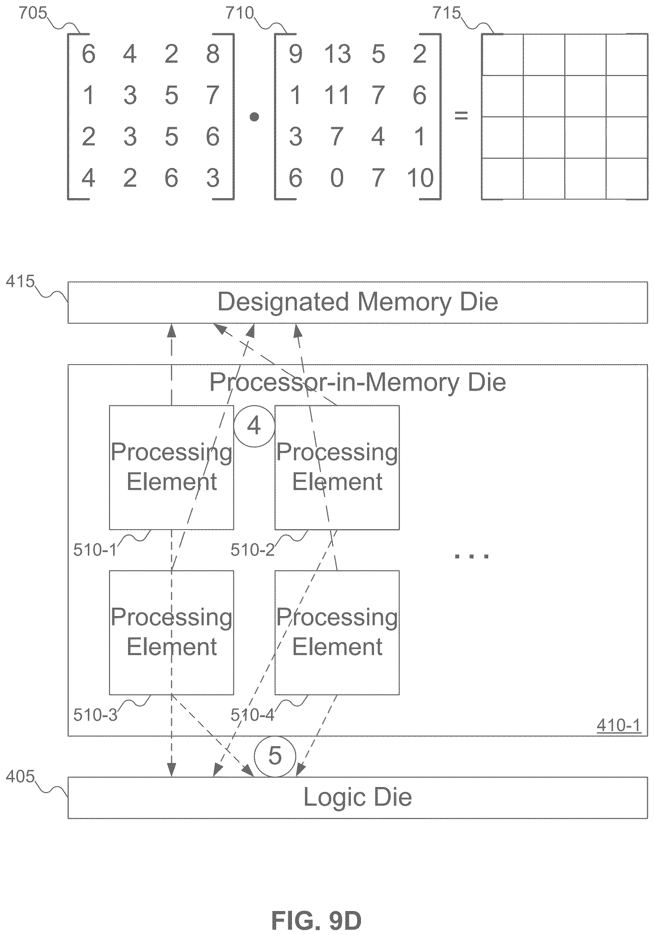

FIGs. 9A-9D show a data flow diagram for processing elements 510 of FIG. 5 to perform a matrix multiplication, according to embodiments of the disclosure. In FIG. 9A, at step 1, logic die 405 may load input matrices 705 and 710 into designated memory die 415.

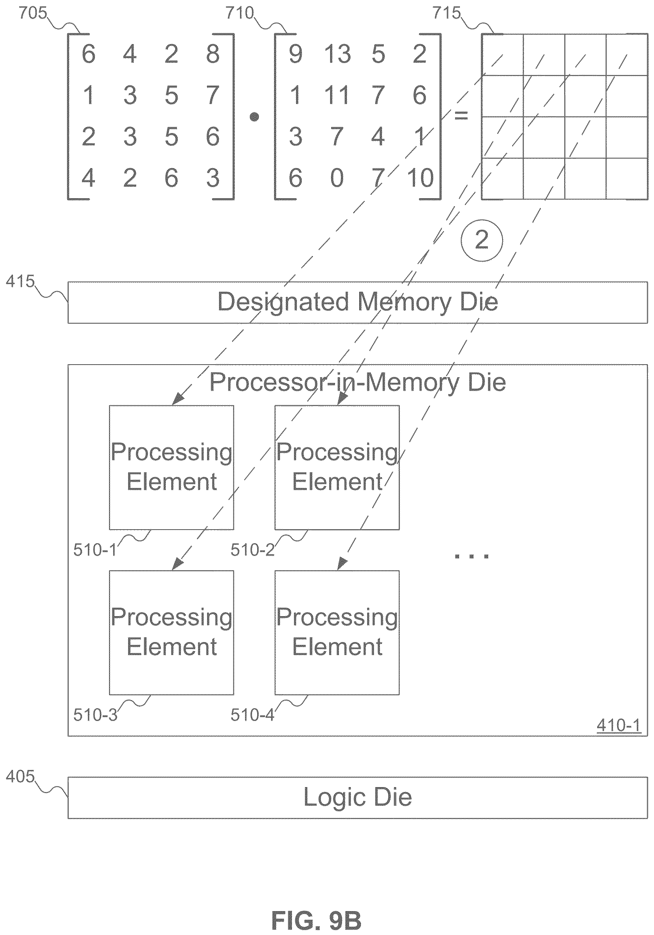

In FIG. 9B, at step 2, logic die 405 may assign processing elements 510 to calculate various entries in output matrix 715. To assign tasks to processing elements 510, the size of the input matrices 705 and 710, as well as the precision of the calculation, may be a factor. For example, the size of input matrices 705 and 710 may affect how much data from each input matrix 705 and 710 may be stored in processing elements 510, and the precision of the calculation may also impact how much data may be stored in processing elements 510. Based on this information, processing elements 510 might be assigned to partially calculate an element in output matrix 715, to wholly calculate an element in output matrix 715, or to calculate multiple elements in output matrix 715. For example, if memory array 305 of FIG. 3 is 1024×1024 cells in size, then memory array 305 of FIG. 3 may store 1,048,576 bits, or 131,072 bytes, of data. If each value in input matrices 705 and 710 uses 4 bytes, then memory array 305 of FIG. 3 may store up to 32,768 elements. If input matrices 705 and 710 both have 32,768 rows and columns, then processing elements 510 may each store half of a row or column from input matrices 705 and 710, and therefore may each generate a partial result (with partial results being combined later to produce the elements in output matrix 715). If input matrices 705 and 710 both have 16,384 rows and columns, then processing elements 510 may each store one row and column from input matrices 705 and 710, and therefore processing elements 510 may each calculate one element in output matrix 715. And if input matrices 705 and 710 are smaller than that, processing elements 510 might each process more than one element in output matrix 715.

Note that the assignment of processing elements 510 to calculate particular elements in output matrix 715 may be more internal to logic die 405 than actually involving data flow to processing elements 510. Processing elements 510 may calculate particular results, but might not need to know which entries in output matrix 715 they calculate. However, as processing elements 510 might know where they are to store the output of their calculations, logic die 405 may provide this information to processing elements 510 in step 2. Other information that logic die 405 might provide to processing elements 510 in step 2 may include precision 615 indicating the number of bits used in each value and/or number of elements 620 in a given row/column of input matrices 705 and 710.

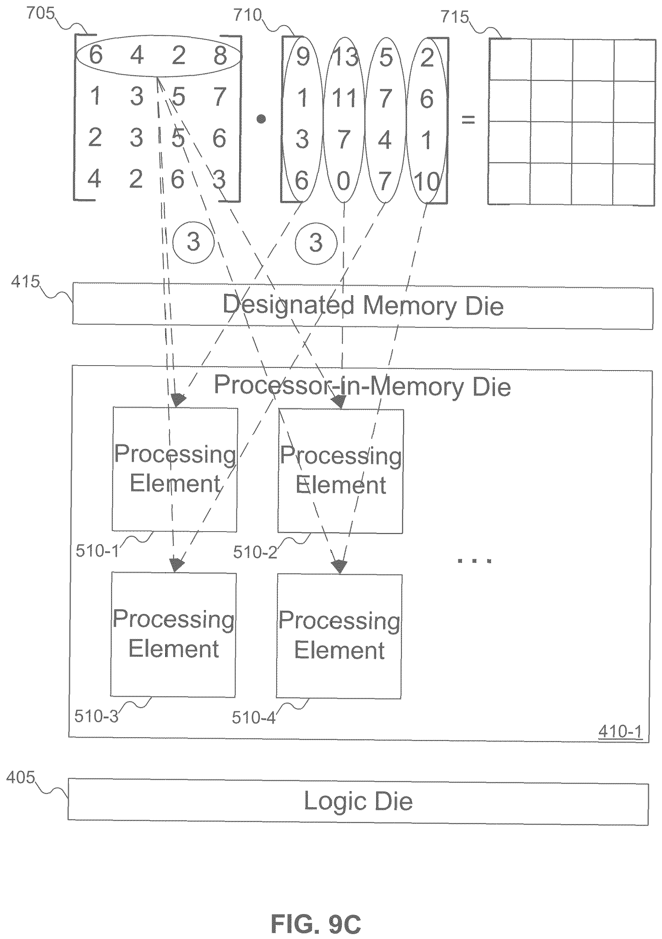

In FIG. 9C, at step 3, logic die 405 may load data from input matrices 705 and 710 from designated memory die 415 into mats 305 of FIG. 3 of processing elements 510. For example, continuing the simplified base 10 example of FIG. 7, the first row of input matrix 705 may be loaded into mats 305 of FIG. 3 of each processing element 510, with different columns of input matrix 710 loaded (transposed into rows) also loaded into mats 305 of FIG. 3 of each processing element 510. That is, processing element 510-1 may be loaded with the first row of input matrix 705 and the first column of input matrix 710, processing element 510-2 may be loaded with the first row of input matrix 705 and the second column of input matrix 710, and so on.

Note that steps 2 and 3 may be combined: steps 2 and 3 do not need to be considered separate steps.

While the above describes logic die 405 as loading the appropriate data into mats 305 of FIG. 3 of processing elements 510, in some embodiments of the disclosure, logic die 405 may inform processing elements 510 where the data they are to process is stored in designated memory die 415. Processing elements 510 may then go retrieve the data they are to process themselves, rather than logic die 405 being responsible for that operation.

Once processing elements 510 have been loaded with the appropriate data and other relevant information, processing elements 510 may then perform the requested calculations on the data stored in their respective mats 305 of FIG. 3.

Once processing elements 510 have finished processing the data in their respective mats 305 of FIG. 3, then at step 4, processing elements 510 may then store their outputs in designated memory die 415, at the addresses specified by logic die 405 as part of steps 2 and/or 3. Alternatively, logic die 405 may access the outputs from processing elements 510 and may store those outputs in designated memory die 415 (which may simplify the logic of processing elements 510). Then, at step 5, processing elements 510 may notify logic die 405 that processing is complete. (To avoid confusion regarding what operations are part of what step, the operations of steps 4 and 5 are shown with arrows using different dashes: the long dashes are part of step 4, and the short dashes are part of step 5.)

Note that in some embodiments of the disclosure, processing elements 510 may return the output values to logic die 405 or store the output values in bank buffer 515 of FIG. 5, rather than storing the output values directly in designated memory die 415. In such embodiments of the disclosure, logic die 405 may then be responsible for storing the output values in designated memory die 415 (potentially as a separate step in the data flow not shown in FIGs. 9A-9D.

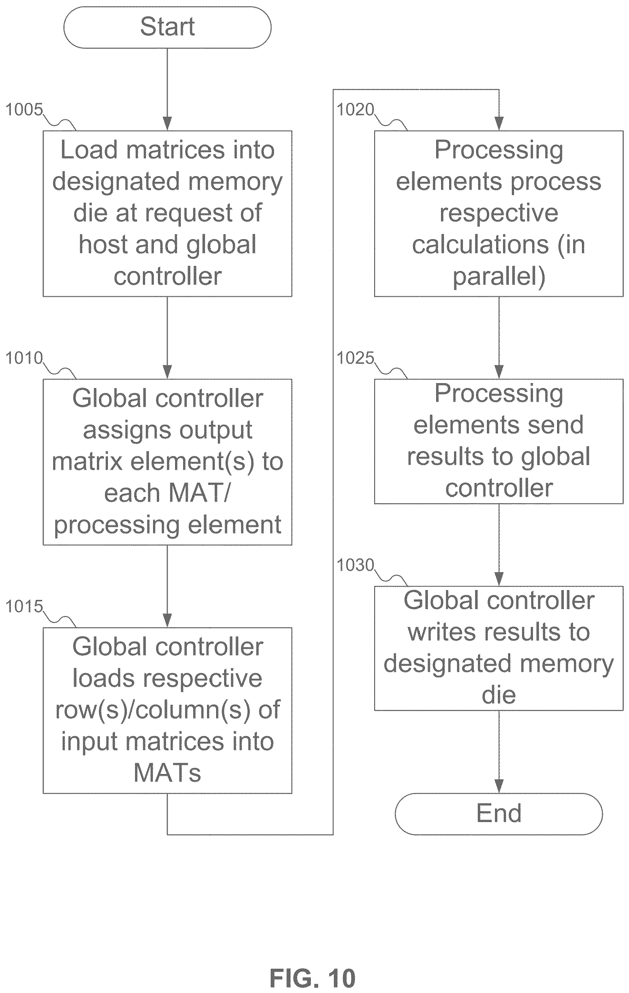

FIG. 10 shows a flowchart of an example procedure for using acceleration device 135 of FIG. 1, according to embodiments of the disclosure. In FIG. 10, at block 1005, at the request of host processor 110 of FIG. 1, logic die 405 of FIG. 4 may load matrices into designated memory die 415 of FIG. 4. This operation may also request that logic die 405 initialize various operations, such as matrix multiplication of input matrices 705 and 710 of FIG. 7. At block 1010, logic die 405 of FIG. 4 may assign processing elements 510 of FIG. 5 to calculate (completely or partially) designated elements of output matrix 715 of FIG. 7. This operation may involve instructing each processing element 510 of FIG. 5 of precision 615 of FIG. 6 to be used, number of elements 620 of FIG. 6 in each row/column of input matrices 705 and 710 of FIG. 7, and/or the address(es) where output calculations are to be stored. The address(es) where output calculations may be stored in, for example, register 610 of FIG. 6, bank buffer 515 of FIG. 5, or designated memory die 415 of FIG. 4, or may be sent to logic die 405 of FIG. 4.

At block 1015, logic die 405 of FIG. 4 may load the respective rows/columns (or portions thereof) of input matrices 705 and 710 of FIG. 7 into mats 305 of FIG. 3 in processing element 510 of FIG. 5, wherein the data loaded into each memory array 305 of FIG. 3 of processing elements 510 of FIG. 5 may correspond to the row/column information from input matrices 705 and 710 of FIG. 7 that may be used in calculating the output elements for output matrix 715 of FIG. 7 assigned to the processing elements 510 of FIG. 5. Note that in some situations, if the amount of data used in calculating an element of output matrix 715 of FIG. 7 is too large to store in a single memory array 305 of FIG. 3 of processing element 510 of FIG. 5, then processing element 510 of FIG. 5 might only calculate a partial output element, which may be combined with one or more other partial output elements of other processing elements 510 of FIG. 5 to produce the final output element of output matrix 715 of FIG. 7. Then, in response to an instruction from logic die 405 of FIG. 4, at block 1020, processing elements 510 of FIG. 5 may perform their respective calculations. Because processing elements 510 of FIG. 5 may not depend on each other, processing elements 510 of FIG. 5 may operate in parallel, expediting total calculation. At block 1025, processing elements 510 of FIG. 5 may send the results of the output calculations to logic die 405 of FIG. 4, either by writing the output calculations to the designed address(es) in bank buffer 515 or designated memory die 415, or by sending the output calculations by signal to logic die 415 of FIG. 4. Finally, assuming that processing elements 510 of FIG. 5 did not write the output calculations directly to designated memory die 415 of FIG. 4, at block 1030, logic die 405 of FIG. 4 may write the output calculations to designated memory die 415 of FIG. 4.

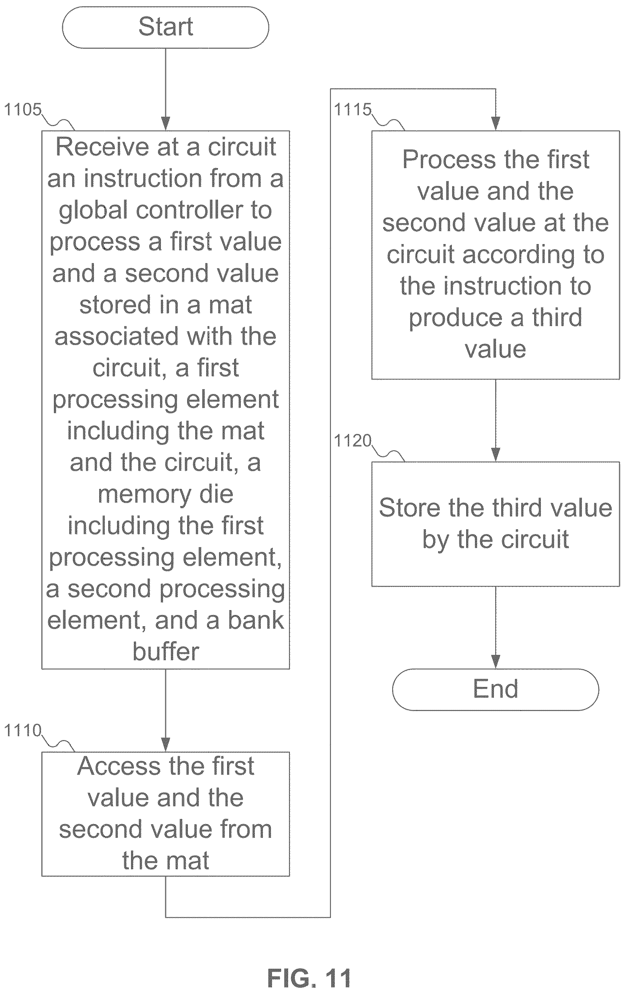

FIG. 11 shows a flowchart of an example procedure for processing elements 510 of FIG. 5 to perform matrix multiplication, according to embodiments of the disclosure. In FIG. 11, at block 1105, processing element 510 of FIG. 5 may receive an instruction from logic die 405 of FIG. 4 for MAC 605 of FIG. 6 to process two values that are stored in memory array 305 of FIG. 3 in processing element 510 of FIG. 5 associated with MAC 605 of FIG. 6. For example, processing element 510 of FIG. 5 may be instructed to process values such as a row from input matrix 705 of FIG. 7 and a column from input matrix 710 of FIG. 7, each of which may contain one or more values. Processing element 510 of FIG. 5 itself may be part of a memory die including a second processing element 510 of FIG. 5 and bank buffer 515 of FIG. 5. At block 1110, the values may be accessed from memory array 305 of FIG. 3 in processing element 510 of FIG. 5. The values may be accessed from memory array 305 of FIG. 3 in processing element 510 of FIG. 5 by MAC 605 of FIG. 6, or by row circuit 310 of FIG. 6 and sense amplifier 320 of FIG. 6 to be copied into buffer 625 of FIG. 6, from which the values may then be accessed. At block 1115, MAC 605 of FIG. 6 may process the values according to the instruction from logic die 405 of FIG. 4 to produce a third value. For example, the two values may be multiplied together as part of an overall operation by processing element 510 of FIG. 5 to perform matrix multiplication (or partial matrix multiplication). At block 1120, this third value may then be stored by MAC 605 of FIG. 6.

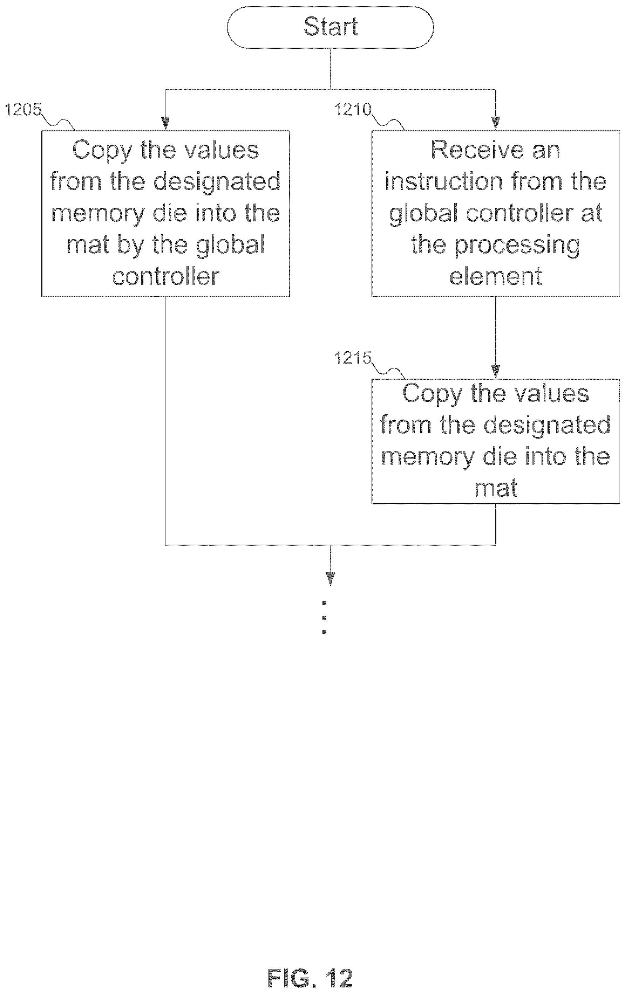

FIG. 12 shows a flowchart of an example procedure for values to be copied into memory array 305 of FIG. 3 in processing element 510 of FIG. 5, according to embodiments of the disclosure. The operations shown in FIG. 12 may be thought of as preparatory to those of FIG. 11, which assumes that the values are already stored in memory array 305 of FIG. 3 in processing element 510 of FIG. 5. In FIG. 12, at block 1205, logic die 405 of FIG. 4 may copy the values from designated memory die 415 of FIG. 4 into memory array 305 of FIG. 3 in processing element 510 of FIG. 5. These values may be values taken from input matrices 705 and 710 of FIG. 7, and may be used as part of a matrix multiplication operation. Alternatively, at block 1210, processing element 510 of FIG. 5 may receive an instruction from logic die 405 of FIG. 4, and at block 1215 processing element 510 of FIG. 5 itself may copy the values from designated memory die 415 of FIG. 4 into memory array 305 of FIG. 3 in processing element 510 of FIG. 5.

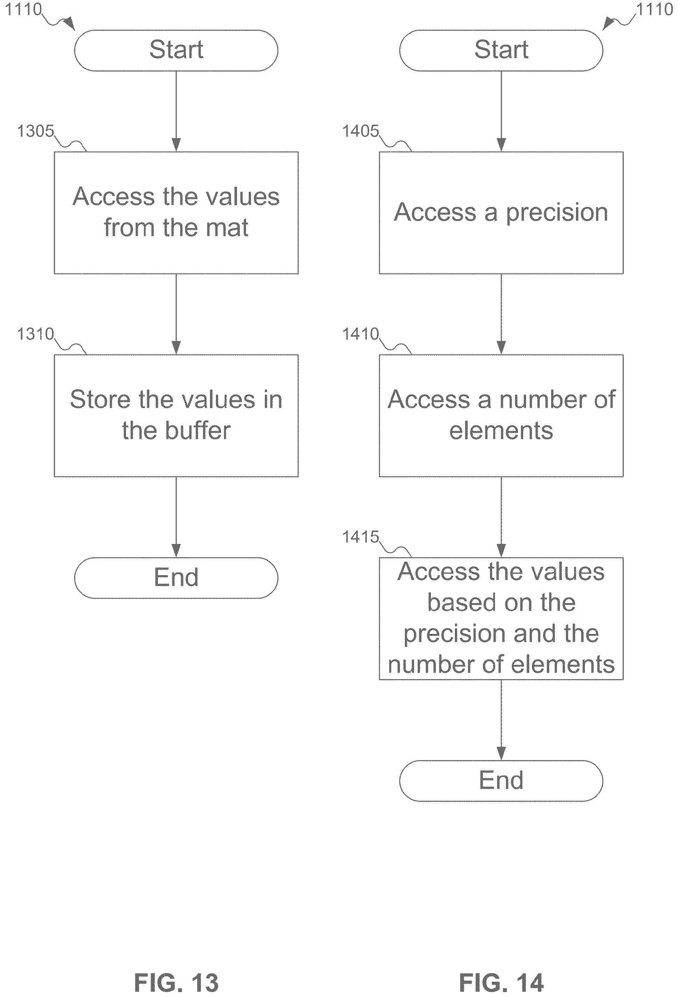

FIG. 13 shows a flowchart of an example procedure for MAC 605 of FIG. 6 to copy values into buffer 625 of FIG. 6, according to embodiments of the disclosure. In FIG. 13, at block 1305, row circuit 310 of FIG. 6 and sense amplifier 320 of FIG. 6 may be used to access the values from memory array 305 of FIG. 3 in processing element 510 of FIG. 5. These values may be values taken from input matrices 705 and 710 of FIG. 7, and may be used as part of a matrix multiplication operation. Then, at block 1310, the values may be stored in buffer 625 of FIG. 6.

FIG. 14 shows a flowchart of an example procedure for MAC 605 of FIG. 6 to determine precision 615 of FIG. 6 to use with the values in memory array 305 of FIG. 3 in processing element 510 of FIG. 5, according to embodiments of the disclosure. In FIG. 14, at block 1405, MAC 605 of FIG. 6 may access precision 615 of FIG. 6. Precision 615 of FIG. 6 may specify how many bits are used for each value stored in memory array 305 of FIG. 3 of processing element 510 of FIG. 5. At block 1410, MAC 605 of FIG. 6 may access number of elements 620 of FIG. 6. Number of elements 620 of FIG. 6 may specify how many values are stored in a given row/column from input matrices 705 and 710 of FIG. 7 in memory array 305 of FIG. 3 in processing element 510 of FIG. 5. Note that MAC 605 of FIG. 6 may receive precision 615 of FIG. 6 and/or number of elements 620 of FIG. 6 directly from logic die 405 of FIG. 4, or MAC 605 of FIG. 6 may read precision 615 of FIG. 6 and/or number of elements 620 of FIG. 6 from register 610 of FIG. 6 (where it may have been stored earlier by logic die 405 of FIG. 4). At block 1415, MAC 605 of FIG. 6 may then access the values from memory array 305 of FIG. 3 in processing element 510 of FIG. 5 based on precision 615 of FIG. 6 and number of elements 620 of FIG. 6, as precision 615 of FIG. 6 may determine how many bits are used to represent each value, and number of elements 620 of FIG. 6 may determine how many values are stored in each row/column of input matrices 705 and 710 of FIG. 7.

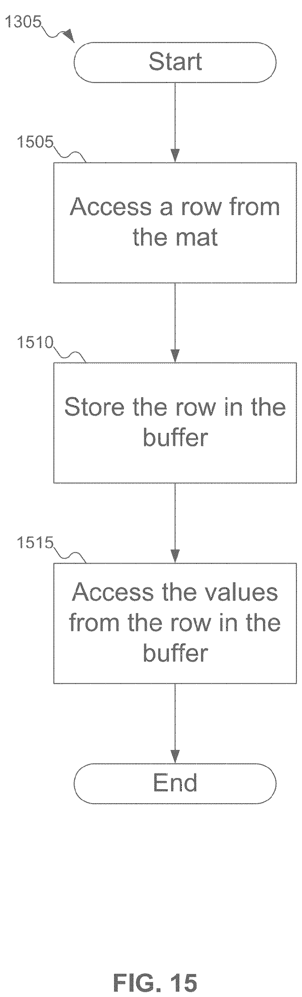

FIG. 15 shows a flowchart of an example procedure for MAC 605 of FIG. 6 to access the values, according to embodiments of the disclosure. While some embodiments of the disclosure may enable accessing values directly from memory array 305 of FIG. 3-for example, when processing element 510 of FIG. 5 includes both row circuit 310 and column circuit 315 of FIG. 3-as discussed with reference to FIG. 6 above, some embodiments of the disclosure may omit column circuit 315 of FIG. 3 to save space in processing element 510 of FIG. 5. In such embodiments of the disclosure, it might not be possible to access individual values directly from memory array 305 of FIG. 3. Instead, at block 1505 of FIG. 6, a row in memory array 305 of FIG. 3 may be read (using, for example, row circuit 310 and/or sense amplifier 320 of FIG. 3). At block 1510, this row may be stored in its entirety in buffer 625 of FIG. 6. Finally, at block 1515, the individual values may be accessed from the row in buffer 625 of FIG. 6, as described with reference to FIGs. 13 and 14 above.

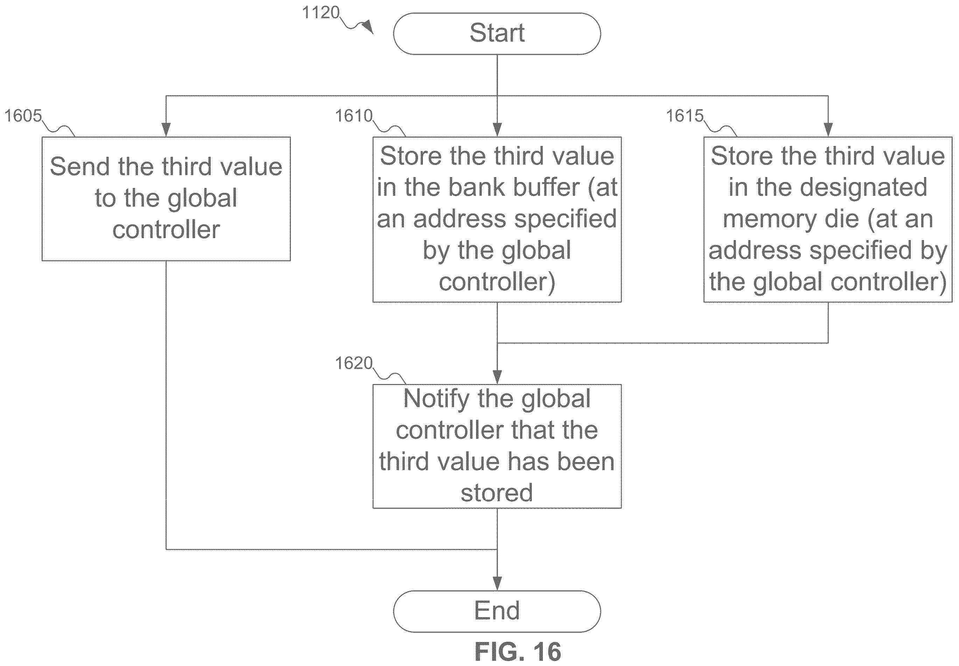

FIG. 16 shows a flowchart of an example procedure for processing elements 510 of FIG. 5 to return output values, according to embodiments of the disclosure. In FIG. 16, at block 1605, processing element 510 of FIG. 5 may send the third value (which may be an output value, calculated from the first and second values) to logic die 405 of FIG. 4. For example, the third value might be the result (either complete or partial) of a matrix multiplication operation.

Alternatively, at block 1610, processing element 510 of FIG. 5 may store the third value in bank buffer 515 of FIG. 5, or at block 1615, processing element 510 of FIG. 5 may store the third value in designated memory die 415 of FIG. 4. Processing element 510 of FIG. 5 may store the third value at an address specified by logic die 405 of FIG. 4 (if processing element 510 of FIG. 5 were to select the address where the third value is stored, it might happen that two different processing elements 510 of FIG. 5 might store their output values at the same address, which might result in data loss. But if address collisions may be avoided, then processing elements 510 of FIG. 5 may select the addresses where they store their output values). Either way, at block 1620, processing element 510 of FIG. 5 may notify logic die 405 of FIG. 4 that the third value has been stored. This notification may involve providing logic die 405 of FIG. 4 with the address where the output value is stored, if processing element 510 of FIG. 5 selects its own address to store its output value.

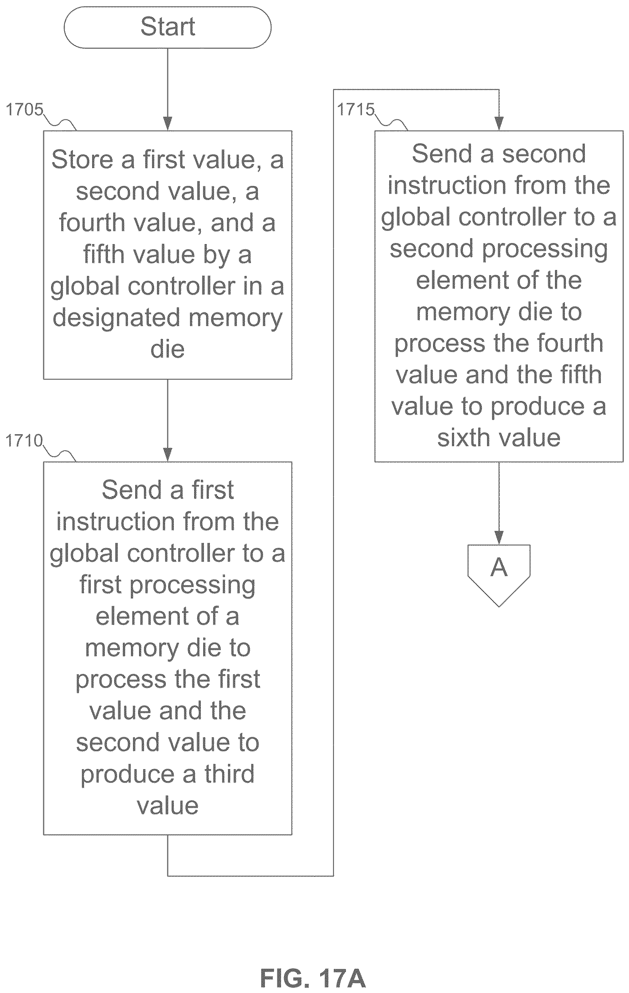

FIGs. 17A-17B show a flowchart of an example procedure for logic die 405 of FIG. 4 to instruct processing elements 510 of FIG. 5 to perform matrix multiplication, according to embodiments of the disclosure. FIGs. 17A-17B describe a generalized implementation of the operations of logic die 405 of FIG. 4, instructing processing elements 510 of FIG. 5 to perform their individual operations without necessarily having any information about what any other processing element 510 of FIG. 5 might be doing. In FIG. 17A, at block 1705, logic die 405 of FIG. 4 may store various values in designated memory die 415 of FIG. 4. For example, these values might be part of input matrices 705 and 710 of FIG. 7, so that processing elements 510 of FIG. 5 may perform matrix multiplication operations. Note that this operation to store values in designated memory die 415 of FIG. 4 may be in response to an instruction from host processor 110 of FIG. 1. At block 1710, logic die 405 of FIG. 4 may send a first instruction to a first processing element 510 of FIG. 5 to process two values to produce a third value (that is, to calculate (in whole or in part) the value for one element in output matrix 715 of FIG. 7), and at block 1715, logic die 405 of FIG. 4 may send a second instruction to another processing element 510 of FIG. 5 to process two other values to produce a sixth value (that is, to calculate (in whole or in part) the value for another element in output matrix 715 of FIG. 7).

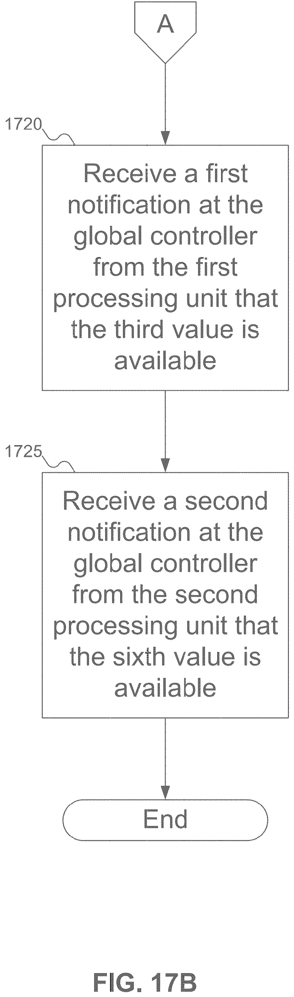

At block 1720 (FIG. 17B), logic die 405 of FIG. 4 may receive a notification from the first processing element 510 of FIG. 5 that the third value is available. Finally, at block 1725, logic die 405 of FIG. 4 may receive a second notification from the second processing element 510 of FIG. 5 that the sixth value is available.

Once logic die 405 of FIG. 4 has been notified by processing elements 510 of FIG. 5 that the third and sixth values are available, logic die 405 of FIG. 4 may perform any desired operations on those values. For example, if the third and sixth values are individual elements in output matrix 715 of FIG. 7 that were calculated as part of a matrix multiplication operation, then logic die 405 of FIG. 4 may transmit those values (potentially along with other output values as part of output matrix 715 of FIG. 7) to processor 110 of FIG. 1. Or, if the third and sixth values are part of a partial matrix multiplication operation, as described with reference to FIG. 8 above, logic die 405 of FIG. 4 may combine the values (for example, by summing the values, potentially in combination with other values produced by processing elements 510 of FIG. 5) to calculate the value for a particular element of output matrix 715 of FIG. 7.

In situations where processing elements 510 of FIG. 5 are calculating partial matrix multiplications, and the values produced by those processing elements 510 of FIG. 5 are to be combined to calculate the actual value that is an element of output matrix 715 of FIG. 7, then it might be more efficient for processing elements 510 of FIG. 5 to transmit the third and sixth values to logic die 405 of FIG. 4, rather than to store those values in designated memory die 415 of FIG. 4. Otherwise, accessing designated memory die 415 of FIG. 4 to store those values (by processing elements 510 of FIG. 5) and then to retrieve them (by logic die 405 of FIG. 4) might become a bottleneck.

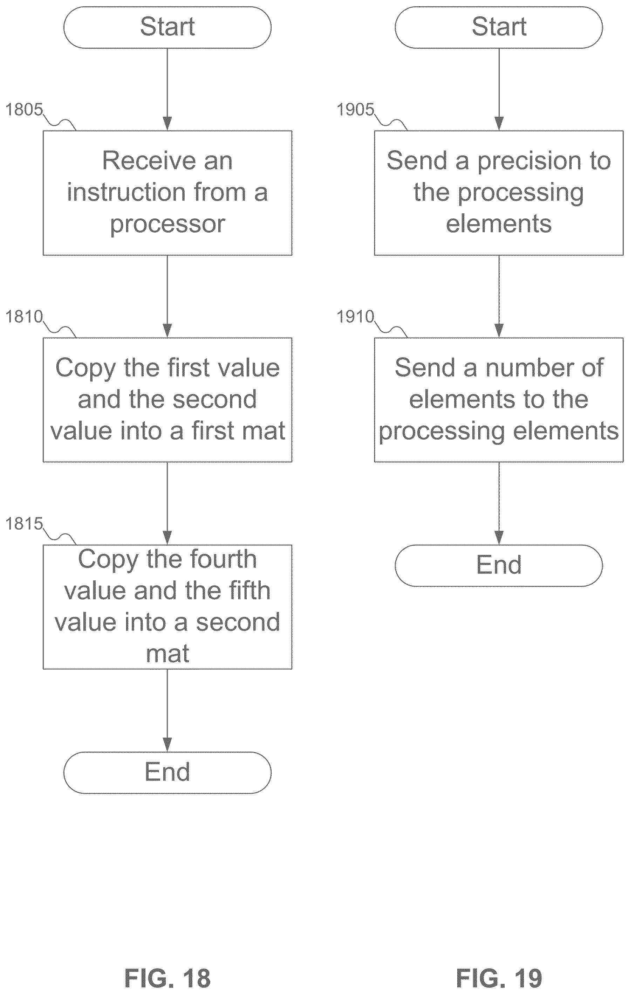

FIG. 18 shows a flowchart of an example procedure for logic die 405 of FIG. 4 to load values into memory array 305 of FIG. 3 in processing element 510 of FIG. 5 for processing elements 510 of FIG. 5 to perform matrix multiplication, according to embodiments of the disclosure. Again, as an example, these values might be part of input matrices 705 and 710 of FIG. 7, so that processing elements 510 of FIG. 5 may perform matrix multiplication operations. In FIG. 18, at block 1805, logic die 405 of FIG. 4 may receive an instruction from host processor 110 of FIG. 1 to perform various operations, such as matrix multiplication. At block 1810, logic die 405 of FIG. 4 may copy the first values into memory array 305 of FIG. 3 in the first processing element 510 of FIG. 5, and at block 1815, logic die 405 of FIG. 4 may copy the second values into memory array 305 of FIG. 3 in the second processing element 510 of FIG. 5. These values may be copied into mats 305 of FIG. 3 in processing elements 510 of FIG. 5 from wherever they might be stored, which may be, for example, designated memory die 415 of FIG. 4. Note that instead of logic die 405 of FIG. 4 doing the copy operations in blocks 1810 and 1815, logic die 405 of FIG. 4 might instead send instructions to processing elements 510 of FIG. 5 to copy the values they need into their mats 305 of FIG. 3 in processing element 510 of FIG. 5.

FIG. 19 shows a flowchart of an example procedure for logic die 405 of FIG. 4 to provide processing elements 510 of FIG. 5 with precision 615 of FIG. 6 to use with the values in memory array 305 of FIG. 3 in processing element 510 of FIG. 5 and number of elements 620 of FIG. 6 in the rows/columns of the input matrices, according to embodiments of the disclosure. For example, logic die 405 of FIG. 4 may inform processing element 510 of FIG. 5 about the number of bits used to represent each value in input matrices 705 and 710 of FIG. 7, as well as the number of values in each row in input matrix 705 of FIG. 7 and each column in input matrix 710 of FIG. 7. In FIG. 19, at block 1905, logic die 405 of FIG. 4 may send precision 615 of FIG. 6 to processing elements 510 of FIG. 5, and at block 1910, logic die 405 of FIG. 4 may send number of elements 620 of FIG. 6 to processing elements 510 of FIG. 5. Note that this "sending" may involve a signal sent to processing elements 510 of FIG. 5 containing the relevant data, or this "sending" may involve storing the appropriate values in register 610 of FIG. 6 of processing elements 510 of FIG. 5. Note, too, that precision 615 of FIG. 6 and number of elements 620 of FIG. 6 may be consistent across all processing elements 510 of FIG. 5: the number of bits used to represent each value in input matrices 705 and 710 of FIG. 7 does not change, nor do the numbers of elements in each row/column in input matrices 705 and 710 of FIG. 7.

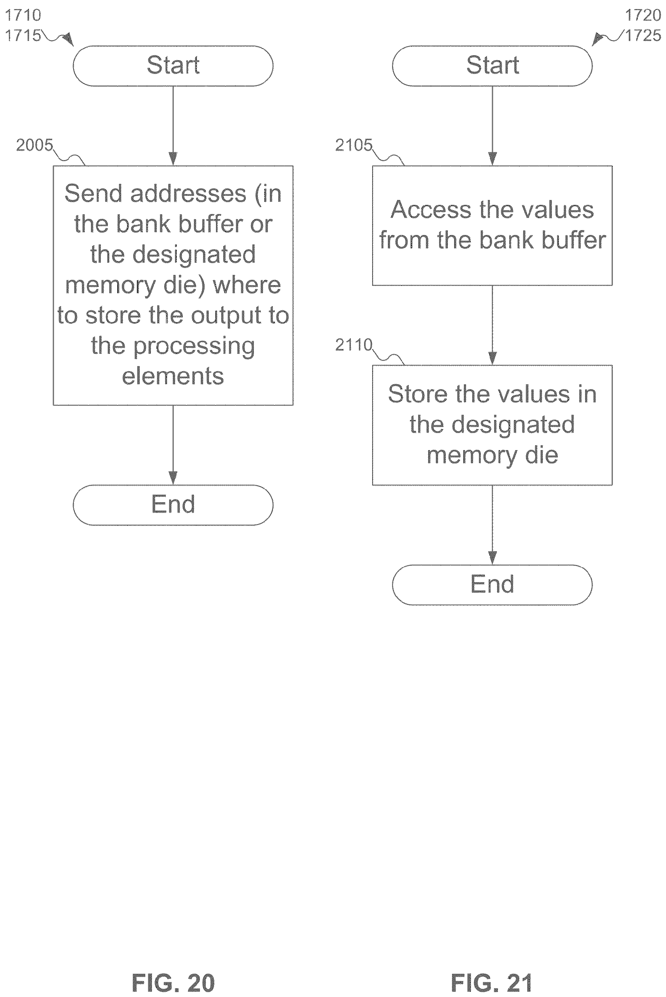

FIG. 20 shows a flowchart of an example procedure for logic die 405 of FIG. 4 to specify the address where processing elements 510 of FIG. 5 may store the output values, according to embodiments of the disclosure. For example, logic die 405 of FIG. 4 may provide processing element 510 of FIG. 5 with an address in either bank buffer 515 of FIG. 5 or in designated memory die 415 of FIG. 4 where the output of the matrix multiplication process may be stored. In FIG. 20, at block 2005, logic die 405 of FIG. 4 may send to processing elements 510 of FIG. 5 the addresses where the output values are to be stored. These addresses may be in bank buffers 515 of FIG. 5 or in designated memory die 415 of FIG. 4, for example.

FIG. 21 shows a flowchart of an example procedure for logic die 405 of FIG. 4 to store the output values produced by processing elements 510 of FIG. 5, according to embodiments of the disclosure. For example, logic die 405 of FIG. 4 may access the output of the matrix multiplication process performed by processing element 510 of FIG. 5 from the address provided to processing element 510 of FIG. 5 in FIG. 20. In FIG. 21, at block 2105, logic die 405 of FIG. 4 may access the output values from bank buffers 515 of FIG. 5, and at block 2110, logic die 405 of FIG. 4 may store the output values in designated memory die 415 of FIG. 4.

In FIGs. 10-21, some embodiments of the disclosure are shown. But a person skilled in the art will recognize that other embodiments of the disclosure are also possible, by changing the order of the blocks, by omitting blocks, or by including links not shown in the drawings. All such variations of the flowcharts are considered to be embodiments of the disclosure, whether expressly described or not.

Embodiments of the disclosure may include an acceleration device leveraging a memory architecture. Processing elements may be included in the memory dies, each of which may include a mat and may process the data stored in the mat. The processing may involve performing matrix multiplication. By having processing performed within the memory die, embodiments of the disclosure offer a technical advantage to improve performing complex operations such as matrix multiplication without having to move large amounts of data into and out of memory to support such operations being performed by a host processor.

The following discussion is intended to provide a brief, general description of a suitable machine or machines in which certain aspects of the disclosure may be implemented. The machine or machines may be controlled, at least in part, by input from conventional input devices, such as keyboards, mice, etc., as well as by directives received from another machine, interaction with a virtual reality (VR) environment, biometric feedback, or other input signal. As used herein, the term "machine" is intended to broadly encompass a single machine, a virtual machine, or a system of communicatively coupled machines, virtual machines, or devices operating together. Exemplary machines include computing devices such as personal computers, workstations, servers, portable computers, handheld devices, telephones, tablets, etc., as well as transportation devices, such as private or public transportation, *e.g*., automobiles, trains, cabs, etc.

The machine or machines may include embedded controllers, such as programmable or non-programmable logic devices or arrays, Application Specific Integrated Circuits (ASICs), embedded computers, smart cards, and the like. The machine or machines may utilize one or more connections to one or more remote machines, such as through a network interface, modem, or other communicative coupling. Machines may be interconnected by way of a physical and/or logical network, such as an intranet, the Internet, local area networks, wide area networks, etc. One skilled in the art will appreciate that network communication may utilize various wired and/or wireless short range or long range carriers and protocols, including radio frequency (RF), satellite, microwave, Institute of Electrical and Electronics Engineers (IEEE) 802.11, Bluetooth^{®}, optical, infrared, cable, laser, etc.

Embodiments of the present disclosure may be described by reference to or in conjunction with associated data including functions, procedures, data structures, application programs, etc. which when accessed by a machine results in the machine performing tasks or defining abstract data types or low-level hardware contexts. Associated data may be stored in, for example, the volatile and/or non-volatile memory, *e.g*., RAM, ROM, etc., or in other storage devices and their associated storage media, including hard-drives, floppy-disks, optical storage, tapes, flash memory, memory sticks, digital video disks, biological storage, etc. Associated data may be delivered over transmission environments, including the physical and/or logical network, in the form of packets, serial data, parallel data, propagated signals, etc., and may be used in a compressed or encrypted format. Associated data may be used in a distributed environment, and stored locally and/or remotely for machine access.

Embodiments of the disclosure may include a tangible, non-transitory machine-readable medium comprising instructions executable by one or more processors, the instructions comprising instructions to perform the elements of the disclosures as described herein.

The various operations of methods described above may be performed by any suitable means capable of performing the operations, such as various hardware and/or software component(s), circuits, and/or module(s). The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or steps of a method or algorithm and functions described in connection with the embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

Having described and illustrated the principles of the disclosure with reference to illustrated embodiments, it will be recognized that the illustrated embodiments may be modified in arrangement and detail without departing from such principles, and may be combined in any desired manner. And, although the foregoing discussion has focused on particular embodiments, other configurations are contemplated. In particular, even though expressions such as "according to an embodiment of the disclosure" or the like are used herein, these phrases are meant to generally reference embodiment possibilities, and are not intended to limit the disclosure to particular embodiment configurations. As used herein, these terms may reference the same or different embodiments that are combinable into other embodiments.

The foregoing illustrative embodiments are not to be construed as limiting the disclosure thereof. Although a few embodiments have been described, those skilled in the art will readily appreciate that many modifications are possible to those embodiments without materially departing from the novel teachings and advantages of the present disclosure. Accordingly, all such modifications are intended to be included within the scope of this disclosure as defined in the claims.

## Claims

1. A processing element (510), comprising:
a first memory array (305) to store at least a first value and a second value;
a first circuit (310, 320) to access the first value and the second value from the first memory array (305); and
a first multiply and accumulate, MAC, circuit (605) to process the first value and the second value to produce a third value,
wherein the processing element (510) is within a memory.

2. The processing element (510) according to claim 1, wherein the memory includes a high bandwidth memory, HBM.

3. The processing element (510) according to claim 1 or 2, wherein the MAC circuit (605) is configured to store the third value in a bank buffer (515-1) at an address specified by a logic die (405).

4. The processing element (510) according to any one of claims 1 to 3, wherein the MAC circuit (605) includes a register to store a precision of the first value and the second value, a number of elements to process in the first memory array (305), or a carry value for use with the MAC circuit (605).

5. The processing element (510) according to any one of claims 1 to 4, wherein:
the processing element (510) further comprises a buffer (625);
the first circuit (310, 320) is configured to access the first value and the second value from the first memory array (305) and to store the first value and the second value in the buffer (625); and
the MAC circuit (605) is configured to process the first value and the second value from the buffer (625) to produce the third value.

6. The processing element (510) according to any one of claims 1 to 5, wherein:
the first memory array (305) further stores a fourth value and a fifth value;
the first circuit (310, 320) is configured to access the fourth value and the fifth value from the first memory array (305); and
the MAC circuit (605) is configured to process the fourth value and the fifth value to produce a sixth value, and to sum the third value and the sixth value to produce a seventh value.

7. The processing element (510) according to any one of claims 1 to 6, wherein the first circuit (310, 320) includes a row circuit (310) and a sense amplifier circuit (320) to read the first value and the second value from the first memory array (305).

8. A processor-in-memory die (410), comprising:
a first processing element (510-1) according to claim 1;
a second processing element (510-2) including:
a second memory array (305) to store at least a fourth value and a fifth value;
a second circuit (310, 320) to access the fourth value and the fifth value from the second memory array (305); and
a second MAC circuit (605) to process the fourth value and the fifth value to produce a sixth value; and
a bank buffer (515-1) where the first processing element (510-1) may store the third value and the second processing element (510-2) may store the sixth value.

9. The processor-in-memory die according to claim 8, wherein the processor-in-memory die (410) includes a high bandwidth memory, HBM, die.

10. The processor-in-memory die according to claim 8 or 9, wherein the first MAC circuit (605) includes a register to store a precision of the first value and the second value, a number of elements to process in the first memory array (305), or a carry value for use with the first MAC circuit (605).

11. The processor-in-memory die according to any one of claims 8 to 10, wherein:
the first processing element (510-1) further includes a first buffer (625); and
the second processing element (510-2) further includes a second buffer (625).

12. The processor-in-memory die according to any one of claims 8 to 11, further comprising:
a first bank (505-1), including the first processing element (510-1), the second processing element (510-2), and the bank buffer (515-1); and
a second bank (505-2), including:
a third processing element (510-5);
a fourth processing element (510-6); and
a second bank buffer (515-2).

13. The processor-in-memory die according to any one of claims 8 to 12, wherein:
the first memory array (305) further stores a seventh value and an eighth value;
the first circuit (310, 320) is configured to access the seventh value and the eighth value from the first memory array (305); and
the first MAC circuit (605) is configured to process the seventh value and the eighth value to produce a ninth value, and to sum the third value and the ninth value to produce a tenth value.

14. A method, comprising:
receiving (1105) at a multiply and accumulate, MAC, circuit (605) an instruction from a logic die (405) to process a first value and a second value stored in a memory array (305) associated with the MAC circuit (605), a first processing element (510-1) including the memory array (305) and the MAC circuit (605), a processor-in-memory die (410) including the first processing element (510-1), a second processing element (510-2), and a bank buffer (515-1);
accessing (1110) the first value and the second value from the memory array (305);
processing (1115) the first value and the second value at the MAC circuit (605) according to the instruction to produce a third value; and
storing (1120) the third value by the MAC circuit (605).

15. The method according to claim 14, wherein accessing (1110) the first value and the second value from the memory array (305) includes:
accessing the first value and the second value from the memory array (305) by the MAC circuit (605); and
storing the first value and the second value in a buffer (625) by the MAC circuit (605), the first processing element (510) further including the buffer (625).
